# EUROPÄISCHE PATENTSCHRIFT

(11) **EP 2 130 236 B1**
(45) Veröffentlichungstag und Bekanntmachung des Hinweises auf die Patenterteilung: **23.05.2012**
(21) Anmeldenummer: 09718468.3
(22) Anmeldetag: 05.03.2009
(51) Int. Cl.: H02N 2/00, H01L 41/09, H01L 41/083

(54) **ULTRASCHALLMOTOR**
ULTRASONIC MOTOR
MOTEUR ULTRASONIQUE

(30) Priorität: 07.03.2008 DE 102008012992
(43) Veröffentlichungstag der Anmeldung: 09.12.2009
(73) Patentinhaber: Physik Instrumente (PI) GmbH & Co. KG, 76228 Karlsruhe (DE)
(72) Erfinder: WISCHNEWSKIY, Wladimir, 76337 Waldbronn (DE); WISCHNEWSKIJ, Alexej, 76744 Wörth (DE)
(74) Vertreter: Meissner, Bolte & Partner
(86) Internationale Anmeldenummer: PCT/EP2009/052565
(87) Internationale Veröffentlichungsnummer: WO 2009/109606

(56) Entgegenhaltungen:
- EP-A- 1 267 425
- DE-A1- 19 938 954
- DE-A1-102005 039 358
- US-A1- 2004 189 155
- US-A1- 2005 062 367

## Beschreibung

Die Erfindung gehört zur Gruppe von Ultraschallantriebsvorrichtungen mit einem Multilayeraktor, die in miniaturisierten elektromechanischen Systemen eingesetzt werden können und die hochpräzise sich bewegende Teile, wie Linsen oder optische Linsengruppen, Objektive, Magnet- oder optische Köpfe von Speichereinrichtungen bzw. miniaturisierte Stelltische und ähnliches enthalten.

Bekannt sind Ultraschallmotoren mit Multilayerultraschallaktoren wie z. B. aus den Patentschriften US 6,081,063; US 7,205,703 B2; US 7,211,929 B2; US 2007/0108869 A1. In allen diesen Motoren ist der Aktor als Platte ausgeführt, die auf die erste Längs- und die zweite Biegemode der Schwingungen abgestimmt ist. Das bedeutet, dass während des Betriebs des Motors in der Platte gleichzeitig die erste Längs- und die zweite Biegemode der Schwingungen erregt werden. Dabei erfolgt die Erregung des Aktors durch eine elektrische Spannung gleicher Frequenz. Damit eine optimale Bewegungsbahn des Friktionselementes entsteht, unterscheiden sich die Frequenzen der Längs- und Biegeresonanz etwas voneinander. Deshalb weisen die Frequenz-Phasencharakte-ristiken dieser Aktoren zwei nah zueinander liegende Nullen auf. Dabei befindet sich die Erregerfrequenz des Aktors üblicherweise nah zu diesen Nullen, d.h. in einem nichteindeutigen Bereich der Frequenz-Phasencharakteristiken.

Durch Änderung der Temperatur oder durch den Einfluss starker wirkender Kräfte verschieben sich die Resonanzfrequenzen der Platte etwas, so dass die Erregerfrequenz des Aktors auch verändert werden muss. Damit die Erregerfrequenz konstant gehalten werden kann, wird die Erregervorrichtung so aufgebaut, dass sie dem Phasensignal folgen kann. Die nicht eindeutige Frequenz-Phasencharakteristik hat jedoch ein instabiles Verhalten der Erregervorrichtung zur Folge, wodurch ein spontanes, periodisches Umschalten von einer Frequenz auf eine andere Frequenz auftreten kann. Dies verschlechtert die Funktionsstabilität der Motoren, führt zum Auftreten akustischer Geräusche und zur Erhöhung des Abriebs des Friktionskontaktes.

Die Verwendung der Biege-Schwingungsmode führt zusätzlich zu einer Verschlechterung des Wirkungsgrads des Aktors, so dass es nicht möglich ist, einen solchen Aktor mit einem ausreichend steifen beweglichen Element zu beauflagen.

Des weiteren ist ein Ultraschallmotor mit Multilayeraktor bekannt, der die angeführten Nachteile nicht aufweist (siehe DE 10 2005 039 358 A1).

Das Funktionsprinzip dieses Motors beruht auf der Erregung einer asymmetrischen zweidimensionalen Stehwelle in der Aktorplatte. Eine solche Welle weist nur eine Aktorresonanzstelle auf. Die Erregung dieser Welle erfolgt durch einen der zwei Multilayergeneratoren. Die Generatoren sind auf beiden Seiten der durch die Mitte der Plattenlänge des Aktors verlaufenden Schnittebene angeordnet. Die erregte Welle besitzt ein großes im zentralen Teil der Aktorplatte sich befindende Schwingungsmaximum. Erst dieses Maximum ermöglicht die Bewegung des angetriebenen Elements.

Die optimale Wellenform entsteht nur bei einem bestimmten Verhältnis von Plattenlänge zur Plattenhöhe des Aktors. Das Verhältnis muss etwa 2 zu 3 betragen. Wird dieses Verhältnis erhöht oder verringert, ändert sich die Wellenform. Das wiederum führt zu einer starken Verschlechterung der Motorfunktion, d.h. zur Verringerung seiner mechanischen Leistung und zur Erhöhung des Abriebs des Friktionskontaktes. Deshalb ist es bei einer gegebenen Aktorlänge nicht möglich, die Motorhöhe zu verringern. D.h. ein solcher Motor ist nicht als flacher Motor realisierbar. Dies engt die Einsatzmöglichkeiten des Motors für miniaturisierte elektromechanische Systemen ein und zwar besonders dann, wenn die Bauhöhe des Antriebs entscheidend die Brauchbarkeit des Systems bestimmt.

Überdies kann auf dem Motor entsprechend der Patentschrift DE 10 2005 039 358 A1 ein Friktionselement auf einer der Seiten des Aktors angeordnet sein.

Dadurch wird der Aktor mechanisch instabil. Bei einer Erhöhung der Last am angetriebenen Element ändert ein solcher Aktor seine Winkellage. Dies führt zu einer Verschlechterung des Friktionskontaktes, was wiederum zu einer Verringerung der Zugkraft führt. Dadurch verringern sich die Stabilität des Motors und die Positioniergenauigkeit der angetriebenen Elemente.

Ziel der Erfindung ist die Erhöhung der mechanischen Leistung, die Verringerung der Bauhöhe des Aktors, die Verbesserung der mechanischen Stabilität des Aktors, die Verbesserung der Betriebsstabilität, die Verringerung des Abriebs des Friktionskontaktes, die Erhöhung der Positioniergenauigkeit, die Verringerung der Geräuschbildung und die Erhöhung der Betriebsstabilität in einem breiten Temperatur- und Lastbereich.

Der Erfindung liegt die Aufgabe zugrunde, einen Ultraschallmotor in einer solchen Ausführung zu schaffen, die aufgrund seiner besonderen konstruktiven Lösung und aufgrund der Verwendung einer neuen akustischen Ultraschallwelle es auf einfache Weise ermöglicht, Eigenschaften zu erreichen, die einen positiven Effekt im Verhältnis zum bestehenden Stand der Technik darstellen.

Die gestellte Aufgabe wird dadurch gelöst, dass der vorgeschlagene hochpräzise Ultraschallmotor entsprechend den Merkmalen nach Patentanspruch 1 ausgeführt ist. Die Unteransprüche stellen zweckmäßige Ausgestaltungen dar. Zusätzlich kann die Multilayerplatte rechtwinklig oder Teil eines Rings oder auch in jeder anderen beliebigen Form ausgeführt sein, bei der die mit einem der erwähnten Generatoren erregte asymmetrische Stehwelle ein Spiegelbild der durch den zweiten Generator erzeugten Welle darstellt.

Dadurch erweitern sich die konstruktiven Einsatzmöglichkeiten der vorgeschlagenen Erfindung.

Außerdem kann die Höhe der Multilayerplatte des Aktors gleich oder ein wenig kleiner als ein Viertel seiner Länge betragen. Dies erhöht die vom Motor erzeugte Kraft.

Im vorgeschlagenen Motor können die sich abwechselnden Schichten der Elektroden und die Schichten der piezoelektrischen Keramik, des als rechtwinklige Platte ausgeführten Multilayeraktors parallel zu ihren Hauptebenen oder parallel zu ihren Seitenflächen oder parallel zu ihren Stirnflächen angeordnet sein.

Dadurch ist es möglich, die Größe der Erregerspannung zu variieren.

In einer der vorgeschlagenen Motorvarianten können die sich abwechselnden Schichten der Elektroden und die Schichten der piezoelektrischen Keramik, des als Teil eines Rings ausgeführten Multilayeraktors parallel zu den Hauptebenen der Multilayerplatte angeordnet sein.

Dies vereinfacht die Herstellungstechnologie für die Aktoren.

In dem vorgeschlagenen Ultraschallmotor können die Schichten der Elektroden und der piezoelektrischen Keramik der Multilayerplatte des Aktors bei der Herstellung der Piezokeramik miteinander verbunden werden, so dass sich ein monolithischer Körper bildet. Dies erhöht die Festigkeit des Multilayeraktors.

In verschiedenen Varianten des vorgeschlagenen Motors kann die Oberfläche der Multilayerplatte des Aktors mit einer dünnen Schutzschicht versehen sein.

Dies ermöglicht es, den vorgeschlagenen Motor vor der Einwirkung aggressiver Medien zu schützen.

In einigen Varianten des vorgeschlagenen Motors kann die Multilayerplatte des Aktors ein oder zwei Friktionselemente aufweisen, die auf einer oder zwei der Seitenflächen in dem zentralen Teil angeordnet sind.

Dies erhöht die Verfahrgeschwindigkeit des angetriebenen Elements.

In anderen Motorvarianten kann die Multilayerplatte des Aktors zwei oder vier Friktionselemente aufweisen, die auf einer oder zwei der Seitenflächen in einem Abstand von den Stirnflächen angeordnet sind, der in etwa gleich einem Viertel seiner Länge bezogen auf die Mittellinie ist. Dies erhöht die vom Motor erzeugte Kraft.

In anderen Varianten des vorgeschlagenen Motors können die Friktionselemente aus einem harten abriebfesten Material wie z.B. Oxidkeramik oder einem anderen ähnlichen Material hergestellt werden. Dies verringert den Abrieb des Friktionskontaktes des Motors.

In dem vorgeschlagenen Motor können die Friktionselemente mit einem leicht schmelzenden Glas auf die Oberflächen der Multilayerplatte aufgeschweißt werden. Dies erhöht die Betriebseinsatztemperatur des Motors.

Die Friktionselemente können auch als Streifen aus abriebfestem Glas oder aus mit abriebfestem Material angefülltem Glas ausgeführt werden.

Dies vereinfacht die Herstellungstechnologie des Multilayeraktors.

In verschiedenen Varianten des vorgeschlagenen Motors können die Friktionselemente oder die Seitenflächen der Multilayerplatte des Aktors Führungsriefen mit runder, V-förmiger oder einer anderen Form aufweisen. Außerdem können die Friktionselemente oder die Seitenflächen der Multilayerplatte des Aktors Führungsschienen mit runder, V-förmiger oder einer anderen Form aufweisen. Dies vereinfacht die Motorkonstruktion.

In diesen vorgeschlagenen Motorvarianten können die Führungsriefen oder Führungsschienen abriebfeste Schichten aufweisen. Dies erhöht die Standzeit des Motors.

In anderen Varianten des vorgeschlagenen Motors kann die Multilayerplatte des Oszillators zwei oder vier Halteelemente aufweisen, die auf einer seiner Seitenflächen angeordnet sind. Dies erhöht die Funktionsstabilität des Motors und die Positioniergenauigkeit des angetriebenen Elements.

In einigen Varianten des vorgeschlagenen Motors kann die elektrische Erregervorrichtung als selbsterregender Generator, dessen Erregerfrequenz durch die Resonanzfrequenz des mit ihm verbundenen Oszillators bestimmt wird.

In anderen Varianten des vorgeschlagenen Motors kann die Erregervorrichtung einen spannungsgesteuerten Generator enthalten, dessen Erregerfrequenz durch den Phasendetektor vorgeben wird, dessen Phaseneingang elektrisch mit dem Rückkopplungselement oder mit der Elektrode des Multilayeraktors verbunden ist.

Das eine als auch das andere erhöht die Betriebszuverlässigkeit des Motors. In den Varianten des vorgeschlagenen Motors kann die Erregervorrichtung einen Halbbrücken- bzw. einen Brückenleistungsverstärker aufweisen, der mit dem Multilayeraktor mittels des LC-Reihenfilters verbunden ist, wobei die Kapazität des Kondensators etwa gleich oder etwas größer als die Eingangskapazität des Multilayeraktors ist. Dies erhöht die Güte des Filters und verringert die Energieverluste im Leistungsverstärker.

In einigen Varianten des vorgeschlagenen Motors ist die Erregervorrichtung als selbsterregender Generator ausgeführt, dessen Erregerfrequenz durch die Resonanzfrequenz des mit ihm verbundenen Oszillators bestimmt wird und die einen symmetrischen PWM-Modulator für die Rückkopplungsspannung und einen Generator für modulierte Dreiecksspannung, dessen Frequenz etwa 10- mal größer als die Betriebsfrequenz des Multilayeraktors ist, enthalten kann.

In diesem Fall kann die Erregervorrichtung über das LC-Bandpassfilter mit dem Multilayeraktor verbunden sein, dessen Kondensator durch die elektrische Kapazität des Multilayeraktors gebildet wird, wobei seine Resonanzfrequenz zwischen der Betriebsfrequenz des Aktors und der Modulationsfrequenz des PMW-Modulators liegt.

Dies verringert die Energieverluste in der elektrischen Erregervorrichtung. Im vorgeschlagenen Motor kann die elektrische Erregervorrichtung aus einem Linear-Leistungsverstärker und einer Kompensationsspule, die parallel zum Multilayeraktor geschaltet ist, bestehen. Dies erhöht die Betriebsstabilität des Motors.

Die Erfindung sei nachstehend anhand von Ausführungsbeispielen und Figuren näher erläutert. Hierbei zeigen:
- Abb. 1...15.: Ausführungsvarianten des vorgeschlagenen Ultraschallmotors mit Multilayeraktor
- Abb. 16...19.: Zeichnungen zur Erläuterung der Konstruktion der Generatoren für Ultraschallschwingungen
- Abb. 20, 21.: Zeichnungen von Varianten der Multilayerplatte des Aktors des vorgeschlagenen Motors
- Abb. 22.: Polarisationsrichtungen
- Abb. 23, 24.: Varianten der Elektrodenkonfiguration
- Abb. 25.: Varianten der stromführenden Leiter
- Abb. 26.: Varianten von Friktionselementen
- Abb. 27.: Aktorvarianten
- Abb. 28, 29.: Varianten der angetriebenen Elemente
- Abb. 30.: Aktor mit Haltelementen
- Abb. 31.: Schaltung zur Verbindung von Multilayeraktor mit der Erregerquelle
- Abb. 32.: Frequenzcharakteristiken des Aktors
- Abb. 33.: Abbildungen der Deformationen der Aktoren
- Abb. 34.: Abbildungen der Bewegungsbahnen
- Abb. 35...38.: Elektrische Schaltungen von Varianten der Erregerquelle

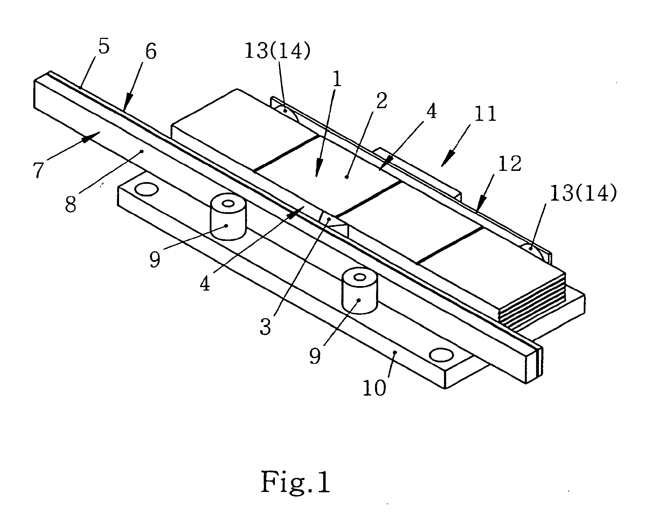

Abb. 1 zeigt eine der Varianten des vorgeschlagenen Ultraschallmotors. Der Motor besteht aus einem als rechtwinklige Multilayerplatte 2 ausgeführten Multilayeraktor 1. Er besteht aus dem Friktionselement 3, dass im zentralen Teil seiner Seitenfläche 4 angeordnet ist. Das Friktionselement 3 wird an die Friktionsoberfläche 5 der abriebfesten Schicht 6 des angetriebenen Elementes 7 angepresst. Das angetriebene Element 7 stellt einen Stab 8 dar, der in den Lagern 9 angeordnet ist. Die Lager 9 befinden sich auf der Grundplatte 10. Das Anpressen des Friktionselementes 3 an die Friktionsoberfläche 5 erfolgt mit Hilfe der Anpressvorrichtung 11, die eine Blattfeder 12 und die Isolierhülsen 13 enthält. In dieser Motorvariante bilden die Isolierhülsen 13 zugleich die Halteelemente 14.

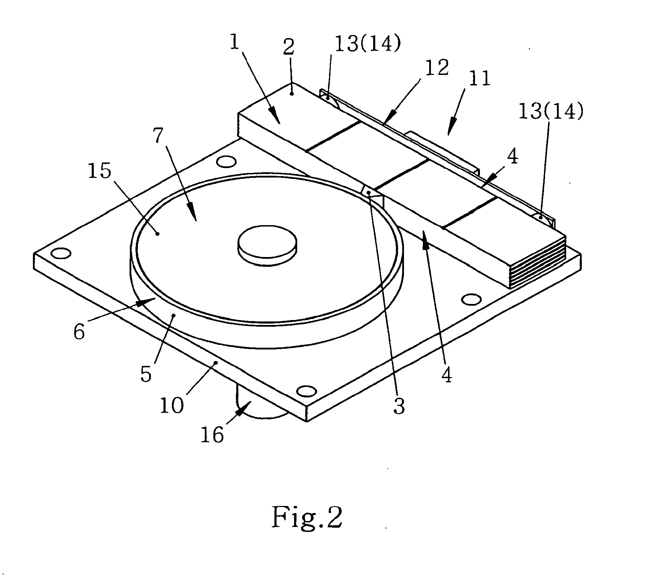

Abb. 2 zeigt eine andere Variante des vorgeschlagenen Motor. In dieser Variante ist das angetriebene Element 7 als Scheibe 15 ausgeführt, die auf der Achse 16 montiert ist. Auf der Scheibe 15 befindet sich die abriebfeste Schicht 6, mit der die Friktionsoberfläche 5 an die des Friktionselementes 3 des Multilayeraktors 1 angepresst wird.

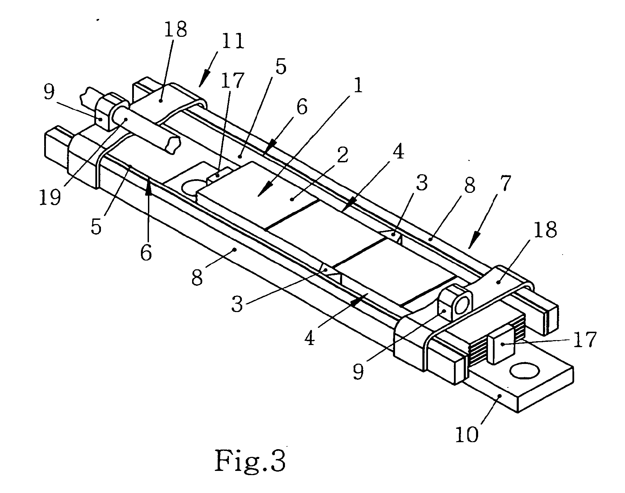

Bei der in Abb. 3 gezeigten Variante besitzt der Motor zwei Friktionselemente 3, die auf den zwei gegenüberliegenden Seiten 4 der rechteckigen Multilayerplatte 2 des Aktors 1 angeordnet sind. Der Multilayeraktor 1 wird durch die zwei Widerlager 17 gehalten, die sich auf der Grundplatte 10 befinden.

Das angetriebene Element 7 dieses Motors besteht aus zwei parallel angeordneten Stäben 8, die abriebfeste Schichten 6 auf der Friktionsoberfläche 5 aufweisen. Die Anpressvorrichtung 11 ist in Form einer oder mehrerer U-förmiger Federn 18 ausgeführt, die die Friktionsoberflächen 5 der Stäbe 8 an die Friktionselemente 3 anpressen.

Das angetriebene Element 7 besitzt die Lager 9, die auf dem Führungsstab 19 verschiebbar sind.

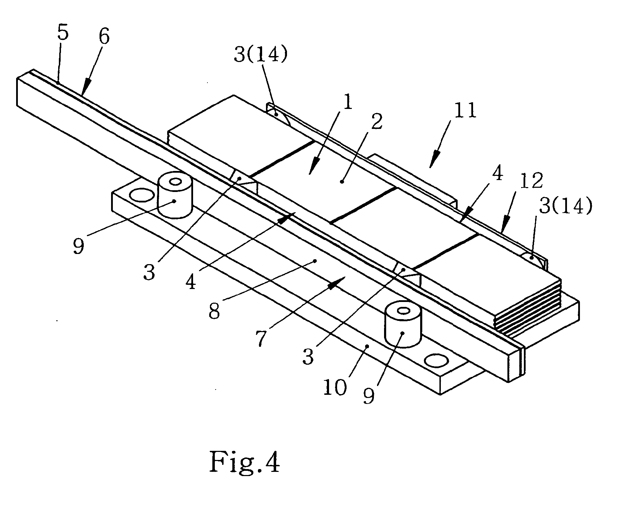

Abb. 4 zeigt einen Motor, bei dem der Multilayeraktor 1 aus zwei auf einer der Seitenflächen 4 der Multilayerplatte 2 angeordneten Friktionselementen 3 besteht.

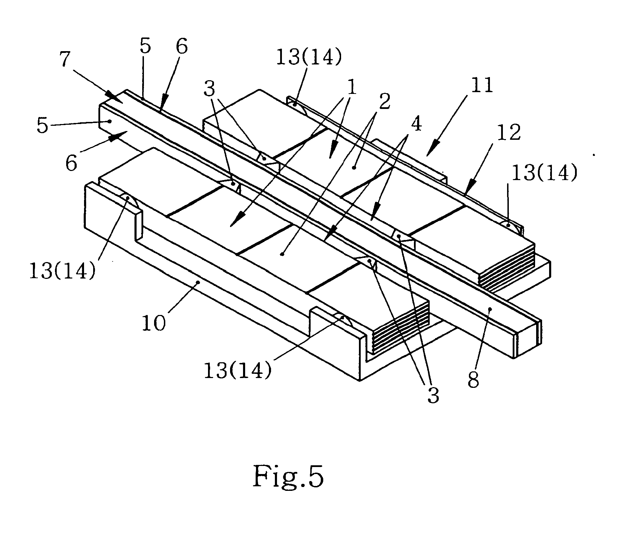

Abb. 5 zeigt noch eine Variante des vorgeschlagenen Motors, der zwei gegenüber angeordnete Multilayeraktoren 1 aufweist, bei denen jeder zwei Friktionselemente 3 enthält. Das angetriebene Element 7 dieses Motors besitzt zwei Friktionselemente 3. Das angetriebene Element dieses Motors ist als Stab 8 ausgeführt, auf dem zwei gegen überangeordnete abriebfeste Schichten 6 mit den Friktionsschichten 5 sich befinden.

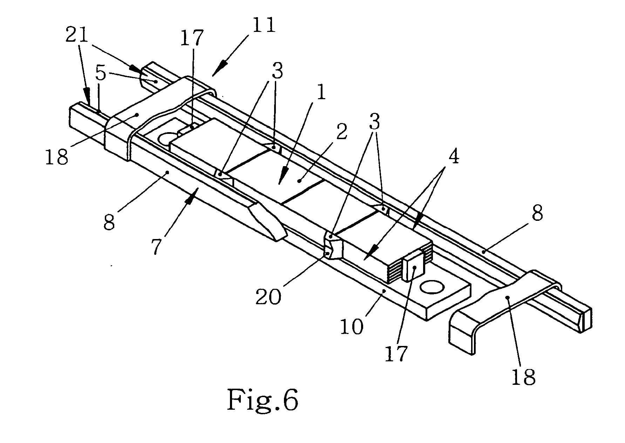

Abb. 6 zeigt eine Motorvariante, bei der der Multilayeraktor 1 vier Friktionselemente 3 aufweist, die sich auf den zwei Seitenflächen 4 befinden. Jedes Friktionselement 3 hat eine Führungsriefe 20 mit V-förmiger oder einer anderen Form.

Das angetriebene Element 7 dieses Motors besteht aus zwei parallel angeordneten Stäben 8, die Führungsschienen 21 mit V-förmiger oder einer anderen Form mit abriebfesten Schichten 6 und den Friktionsoberflächen 5 auf ihnen aufweisen. Die Anpressvorrichtung 11 ist in Form einer oder mehrerer U-förmiger Federn 18 ausgeführt, die die Friktionsoberflächen 5 der Stäbe 8 an die Friktionselemente 3 anpressen.

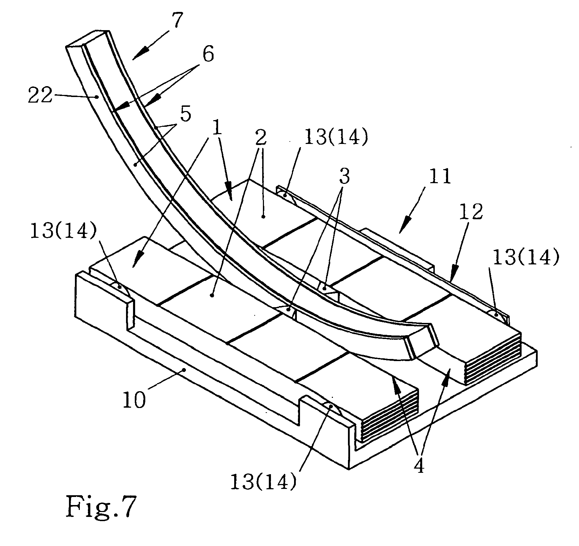

Abb. 7 zeigt einen Motor, bei dem das angetriebene Element 7 als Teil des Rings 22 ausgeführt ist. Dabei befinden sich die abriebfesten Schichten 6 mit den Friktionsoberflächen 5 auf zwei ebenen Flächen des Rings 22.

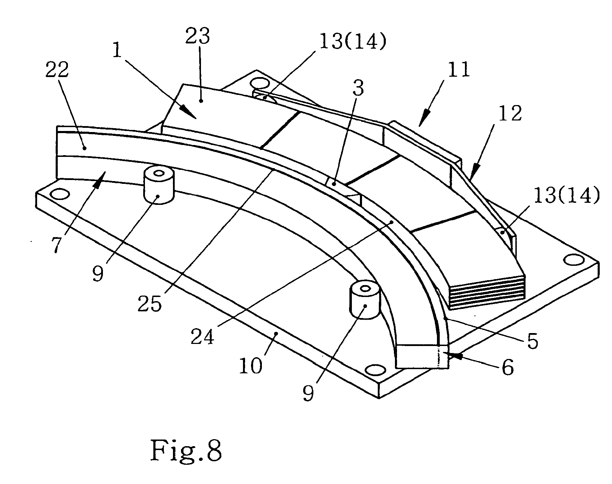

Abb. 8 zeigt einen Motor bei dem der Multilayeraktor 1 als Multilayerplatte, die Form eines Teils des Rings 23 hat, ausgeführt ist. Dabei ist das Friktionselement 3 des Aktors 1 im zentralen Teil der inneren Zylinderoberfläche 24 angeordnet.

Das angetriebene Element 7 des Motors kann ebenfalls die Form eines Teils des Rings 25 haben, der gleichachsig mit dem Aktor 1 angeordnet ist. Die abriebfeste Schicht 6 mit der Friktionsoberfläche 5 befindet sich auf der äußeren Zylinderoberfläche 25 des angetriebenen Elementes 7 als Teil des Rings.

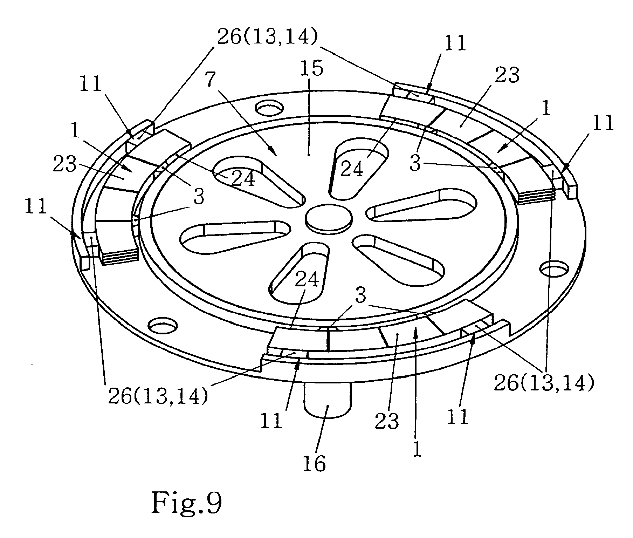

Abb. 9 zeigt einen Motor, der aus drei gleichachsig angeordneten Multilayeraktoren 1 besteht, die als Multilayerplatten ausgeführt sind und die Form eines Teils des Rings 23 haben. Jeder dieser Aktoren besitzt zwei auf den inneren Zylinderoberflächen 24 angeordnete Friktionselemente 3. In diesem Motor werden die Friktionselemente an die Friktionsoberfläche 5 der abriebfesten Schicht 6 durch die elastischen (federnden) Element 26 angepresst, die gleichzeitig die Aufgaben der Isolierhülsen 13 und der Haltelemente 14 wahrnehmen. Das angetriebene Element 7 des Motors ist als Scheibe 15 ausgeführt.

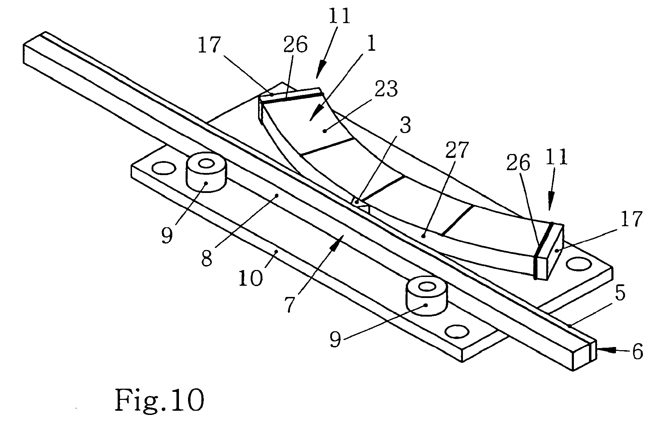

Abb. 10 zeigt eine Variante des vorgeschlagenen Motors mit einem Aktor 1 als Multilayerplatte in Form eines Teils des Rings 23. Dabei ist das Friktionselement 3 auf der äußeren Zylinderoberfläche 27 des Aktors 1 angeordnet. Das angetriebene Element 7 ist als Stab 8 ausgeführt.

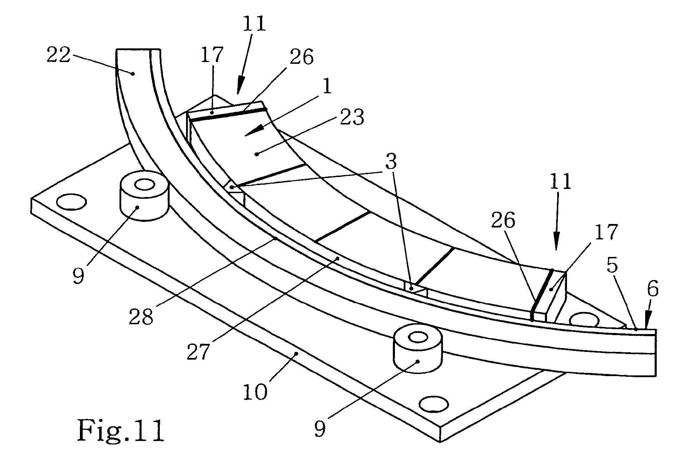

Abb. 11 zeigt noch eine Motorvariante mit dem Aktor 1 als Multilayerplatte als in Form eines Teils des Rings 23. In diesem Motor sind die zwei Friktionselemente 3 auf der äußeren Zylinderoberfläche 27 des Aktors 1 angeordnet. Das angetriebene Element 7 ist ebenfalls als Teil des Rings 22 ausgeführt, bei dem die abriebfeste Schicht 6 sich auf der inneren Zylinderoberfläche 28 befindet.

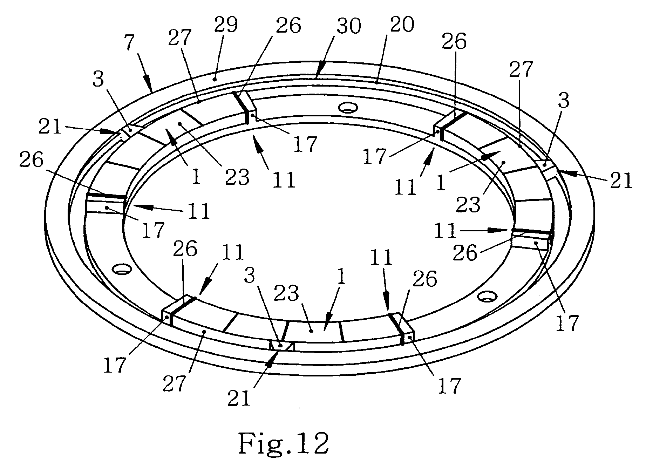

Abb. 12 zeigt einen Ultraschallmotor mit drei Multilayerultraschallaktoren 1, wobei jeder als Multilayerplatte ausgeführt ist und einen Teil des Rings 23 darstellt. Jeder der Aktoren besitzt ein auf der äußeren Zylinderoberfläche 27 des Aktors 1 angeordnetes Friktionselement 3. Das angetriebene Element 7 dieses Motors ist als Ring 29, das den Aktor 1 umfasst, ausgeführt. Auf seiner inneren Oberfläche 30 besitzt der Ring 29 eine Führungsriefe 20 mit V-förmiger Form. In diesem Fall hat das Friktionselement 3 eine Führungsschiene 21 mit V-förmiger Form auf.

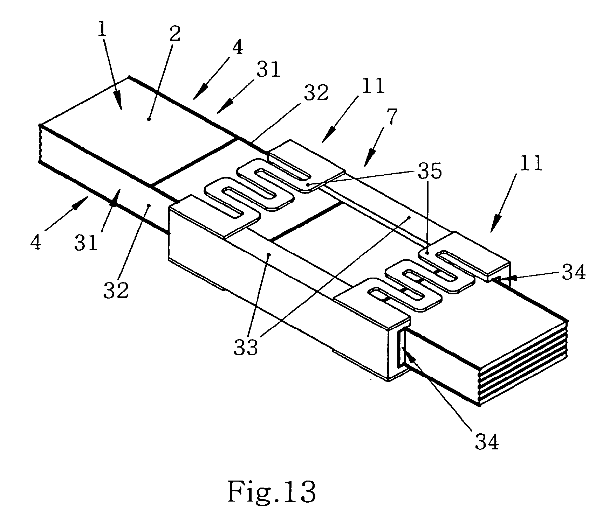

Abb. 13 zeigt eine vorschlagsgemäße Variante des Ultraschallmotors, in dem der Multilayerultraschallaktor 1 als rechtwinklige Multilayerplatte 2 ausgeführt ist. Die Platte 2 hat auf den ebenen Oberflächen 31 der Seitenflächen 4 die Friktionsschichten 32. Dabei besteht das angetriebene Element 7 dieses Motors aus den zwei Stößeln 33. Die Stößel 33 wiederum bestehen aus den Friktionsplatten 34, über die sie Kontakt mit den Friktionsschichten 32 halten. Die Stößel 33 werden mit Hilfe der zweidimensionalen (flachen) Formfedern 35 der Anpressvorrichtung 11 an den Aktor 1 angepresst.

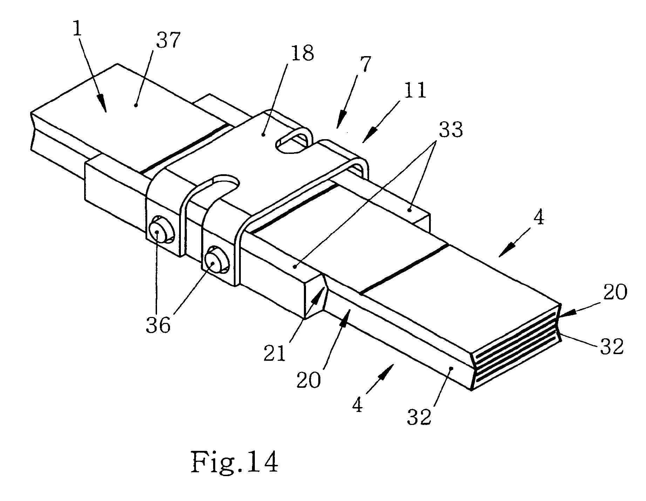

Abb. 14 zeigt einen Ultraschallmotor, bei dem die Stößel 33 an die Seitenflächen 4 des Multilayeraktors 1 mittels der U-förmigen Feder der Anpressvorrichtung 11 angepresst werden. Die Feder 18 hält mit Hilfe der Stifte 36 die Stößel 33 fest.

Bei dieser Motorvariante besitzen die Seitenflächen 4 der Multilayerplatte 37 des Multilayeraktors 1 V-förmige Führungsriefen mit den Friktionsschichten 32, auf denen sich die Stößel 33 mit ihren V-förmigen Führungsschienen 21 bewegen.

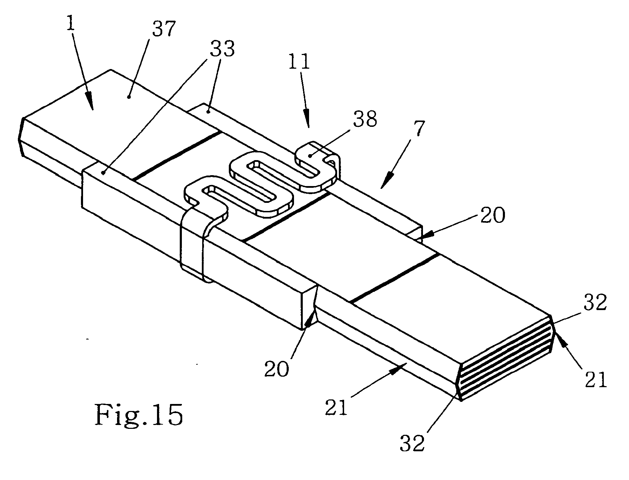

Abb. 15 zeigt eine Variante des Ultraschallmotors, in dem die Seitenflächen 4 der Multilayerplatte 37 des Mutlilayeraktors 1 V-förmige Führungsschienen 21 mit den Friktionsschichten 32 aufweisen. An die Führungsnuten 21 mit ihren V-förmigen Führungsriefen 20 werden die Stößel 33 angepresst. Das Anpressen erfolgt mit Hilfe der dreidimensionalen (volumetrischen) Formfeder 38 der Anpressvorrichtung 11.

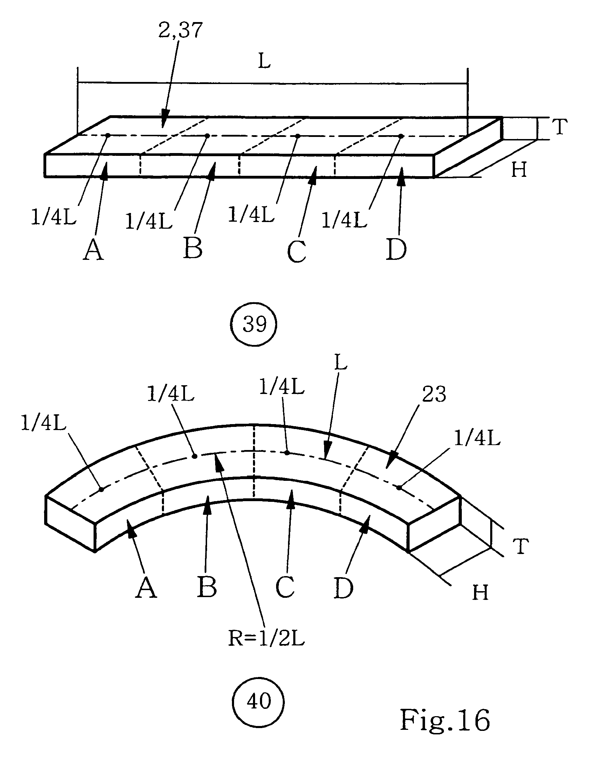

In dem vorgeschlagenem Ultraschallmotor ist die Länge L der Multilayerplatte 2, 37 oder 23 des Multilayeraktors 1 - bezogen auf die Mittellinie (siehe Abb. 16, Position 39, 40) - gleich der Länge der erregten asymmetrischen zweidimensionalen (ebenen) Welle. Die Höhe H der Platte 2, 37 oder 23 wird so gewählt, dass sie gleich ¼ L oder etwas kleiner (0,7...1) ¼ L ist.

Wenn die Platte des Aktors 1 als Teil des Rings 23 ausgeführt ist, wird der Radius r dieser Platte - bezogen auf die Mittelelinie - so ausgewählt, dass er etwa gleich ½ L ist (siehe Abb. 16, Position 40).

Die Multilayerplatte 2, 37 oder 23 des Aktors 1 wird in der Länge L in die vier Zonen A, B, C und D geteilt, wobei die Länge jeder Zone ¼ L beträgt (siehe Abb. 16).

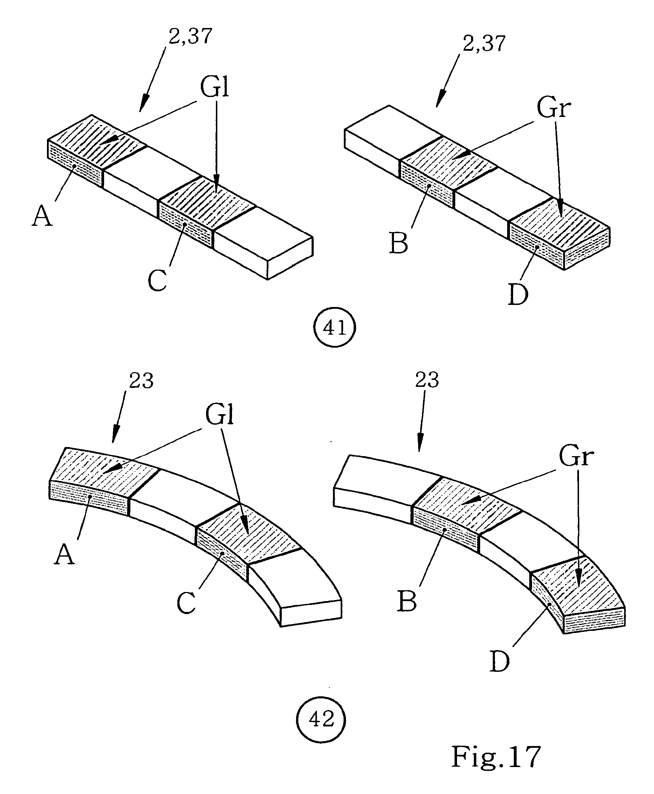

Die Zonen A und C bilden den Generator für Ultraschallschwingungen GI, die Zonen B und D bilden den Generator für Ultraschallschwingungen Gr (siehe Abb. 17 Position 41, 42).

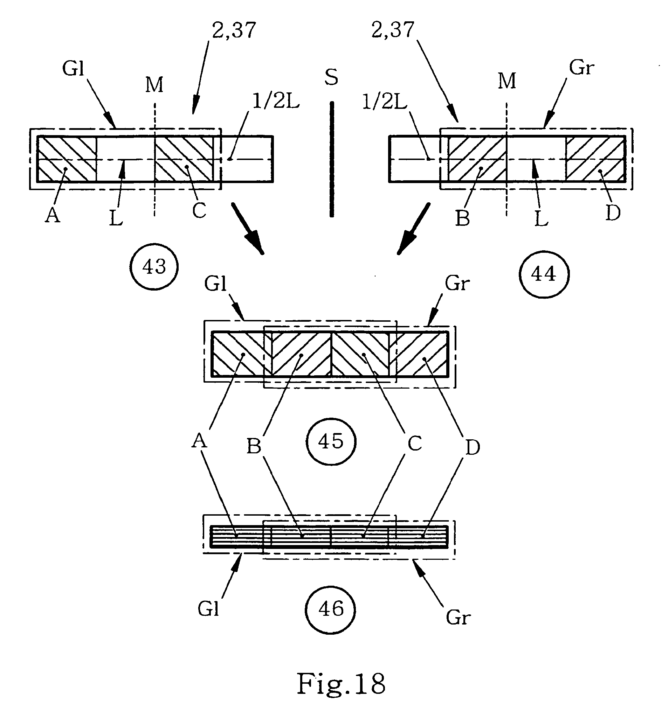

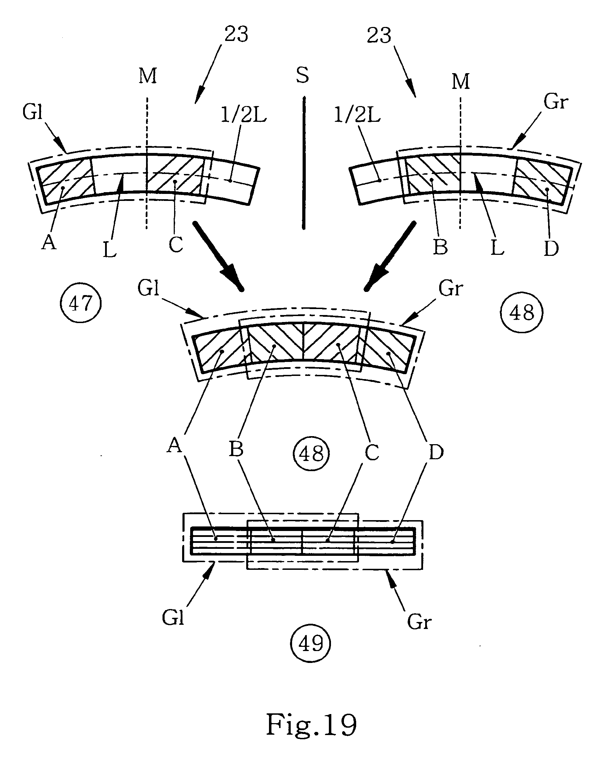

Die Zeichnungen in Abb. 18, 19 erläutern die geometrischen Eigenschaften der Generatoren GI und Gr.

Jeder der Generatoren GI und Gr ist asymmetrisch - bezogen auf die Symmetrieebene M der Platte 2, 37, 23, die durch die die Mittelpunkt der Mittellinie L verläuft - angeordnet, so wie dies in den Positionen 43, 44, 47 und 48 dargestellt ist. Aus diesem Grunde stellen die Generatoren GI und Gr asymmetrische Generatoren dar.

Jeder der Geratoren G I und Gr stellt spiegelbildlich den anderen Generator in der Spiegelebene S dar. Die Ebene S verläuft parallel zur Symmetrieebene M im Abstand von größer ½ L. Die in den Positionen 43, 47 angegebenen Generatoren GI stellen spiegelbildlich die in den Positionen 44, 48 dargestellten Generatoren Gr dar. Gleichermaßen umgekehrt, wobei die in den Positionen 44, 48 dargestellten Generatoren spiegelbildlich die Generatoren GI, die in den Positionen 43, 47 dargestellt sind, bilden.

Die Generatoren GI und Gr in der Multilayerplatte 2, 37, 23 des Multilayeraktors 1 schneiden sich, wie in Positionen 45, 46, 49, 50 der Abb. 18, 19 dargestellt. Der Begriff "schneiden" bedeutet, dass die Generatoren Gr und GI sich gegenseitig asymmetrisch überlagern.

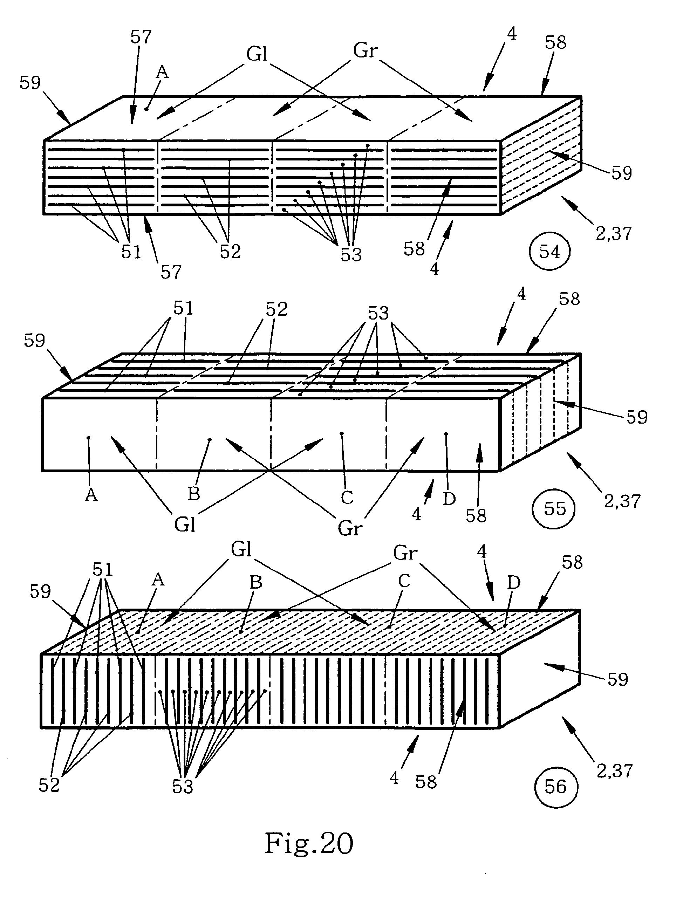

Jeder der Generatoren GI und Gr besteht aus Schichten von Erregerelektroden 51 und Schichten der allgemeinen Elektroden 52 die sich mit den Schichten der Piezokeramik 53 abwechseln (siehe Position 54, 55, 56 in Abb. 20).

Die Dicke der Piezokeramikschicht 53 kann 20...200 Mikrometer und die Dicke der Metallelektroden 52, 53 kann 0,5...10 Mikrometer betragen. Die Piezokeramik muss eine niedrige Herstellungstemperatur von etwa 800...1000°C aufweisen. Die metallischen Schichten der Elektroden 52, 53 müssen diese Herstellungstemperatur für die Piezokeramik aushalten. Als Elektrodenmaterial kann Palladium oder ein Gemisch von Palladium mit Silber verwendet werden.

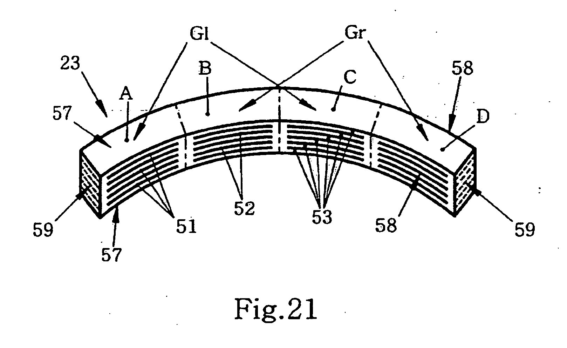

Die Schichten 51, 52, 53 können parallel zu den Hauptflächen 57 der Platte 2, 37, 23 (siehe Position 54 der Abb. 20, 21) bzw. parallel zu den Seitenflächen 59 (siehe Position 53, Abb. 20) angeordnet werden.

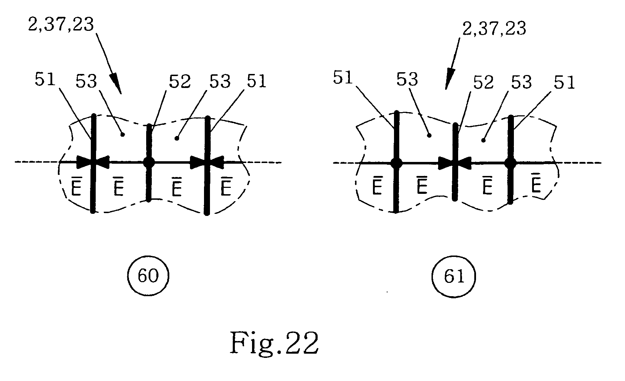

In den Positionen 60, 61 der Abb. 22 sind mit Pfeilen zwei der möglichen Polarisationsrichtungen E der piezokeramischen Schichten 53 zwischen den Elektroden 51 und 52 angeben.

Es wird verdeutlicht, dass der Polarisationsvektor im Wesentlichen senkrecht zur Fläche der Erregerelektroden 51 und der allgemeinen Elektroden 52 verläuft. In der Position 60 sind die Polarisationsvektoren dabei von der allgemeinen Elektrode 52 weggerichtet und in der Position 61 zur allgemeinen Elektrode hingerichtet.

Der Verlauf der Polarisationsvektoren kann sich unterschiedlichen Generatoren voneinander unterscheiden.

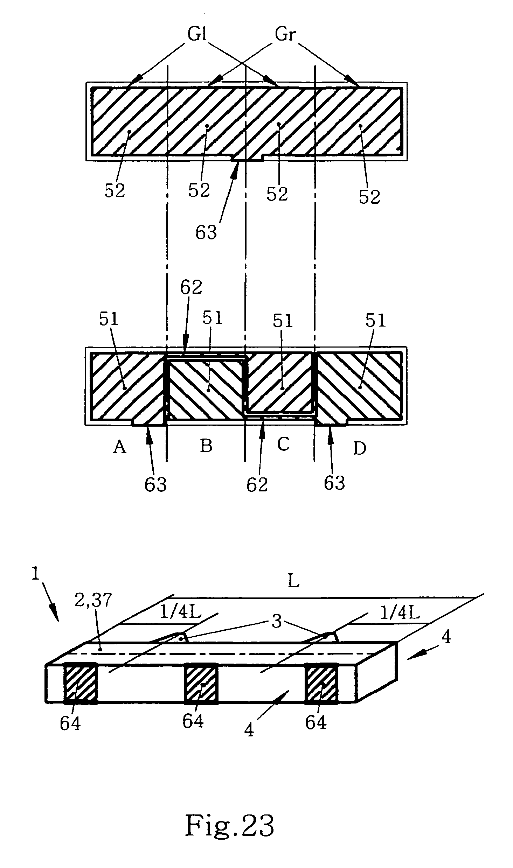

Abb. 23 zeigt mögliche Formen der Elektroden 51 und 52 für einen Multilayeraktor 1 mit den Friktionselementen 3 auf einer seiner Seitenfläche 4.

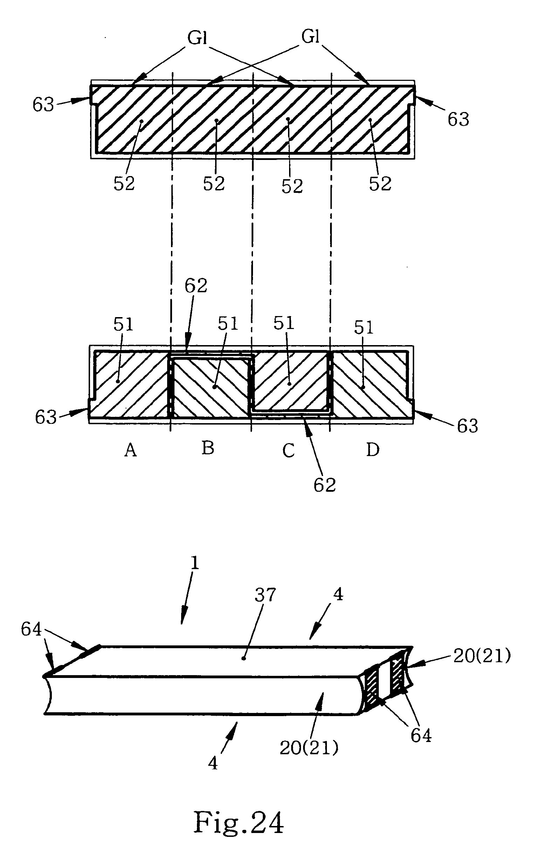

Abb. 24 zeigt die möglichen Formen der Elektroden 51 und 52 für einen Multilayeraktor 1 mit den Führungsriefen 20 auf seinen Seitenflächen 4.

Zur Vereinfachung der Konstruktion sind die allgemeinen Elektroden 52 der Generatoren GI und Gr mit einer kompakten Elektrode verbunden. Die Erregerelektroden 51 sind miteinander über die schmale Verbindungselektrode 62 verbunden. Alle Elektroden weisen Vorsprünge 63 auf, die zur Verbindung dieser Elektroden mit den Kontaktflächen 64 dienen.

Zur Verhinderung von elektrischen Durchschlägen zwischen den Elektroden und Oberflächen der Multilayerplatten 2, 37 und 23 kann die Oberfläche der Platten mit einer dünnen Glasschicht bedeckt sein (in den Zeichnungen nicht dargestellt).

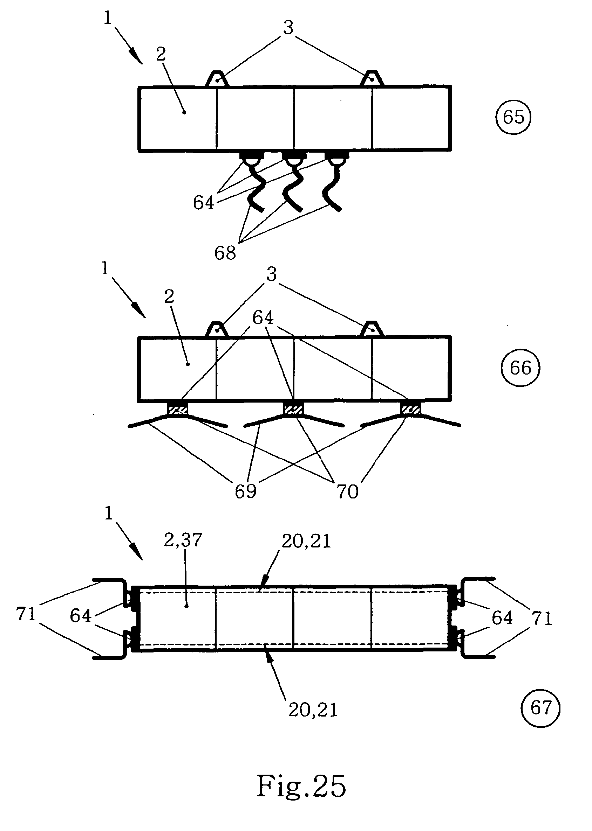

Die Positionen 65, 66, 67 der Abb. 25 zeigen Varianten stromführender Leiter. Als stromführende Leiter können die Kabel 68 verwendet werden, die an die Kontaktflächen 64 (Position 65) angelötet sind. Außerdem können als stromführende Leiter Blattfedern 69 eingesetzt werden, die über die aus leitfähigen Gummi (Position 66) hergestellten Abstandshalter 70 Kontakt mit den Kontaktflächen halten. Die Blattfedern 69 können gleichzeitig in der Anpressvorrichtung 11 zur Erzeugung der Kraft, die die Friktionselemente 3 an die Friktionsoberfläche 5 anpressen, verwendet werden. Es können auch elastische metallische Lamellen 71 als stromführende Leiter verwendet werden, die gleichzeitig den Aktor 1 halten (Position 67).

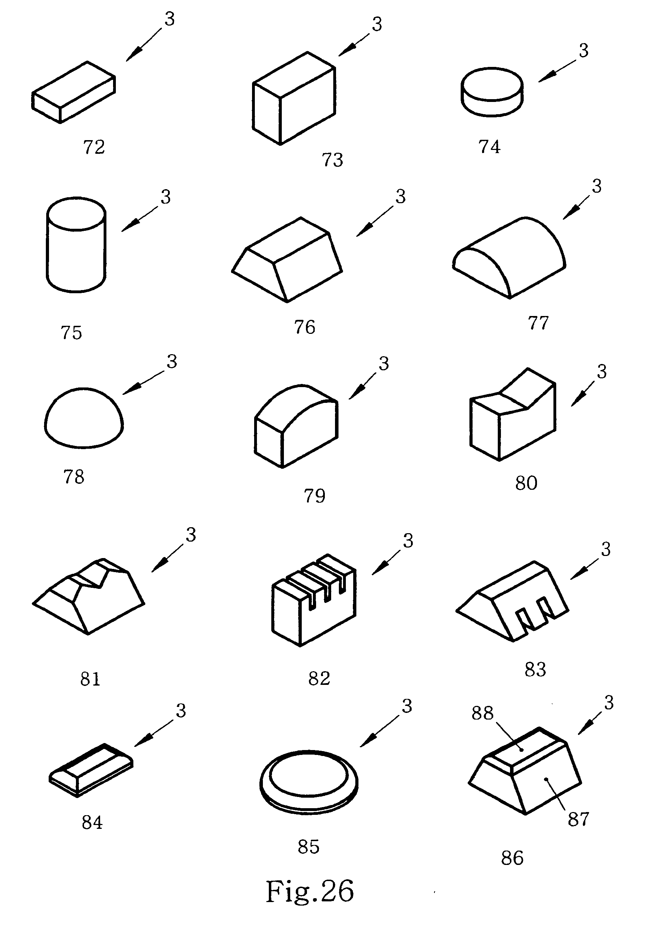

Die Positionen 72...86 in Abb. 26 zeigen die Friktionselemente 3.

Die Friktionselemente 3 (siehe Position 72...83) werden als monolithische Elemente aus abriebfestem Material, wie z.B. Oxidkeramik mit Aluminiumoxid, Zirkoniumoxid, Keramik mit Siliziumnitrid, Siliziumkarbid, Metallkeramik mit Wolframkarbid, Titannitrid oder aus anderer ähnlicher fester abriebfester Keramik gefertigt. Außerdem können die Friktionselemente 3 aus monokristalinen Materialien, die Aluminiumoxid enthalten, wie z.B. Saphir, Rubin oder aus anderen harten abriebfesten Monokristallen, gefertigt werden. Die monolithischen Friktionselemente 3 können auch aus Materialien auf der Basis harter Gläser oder Gläser, die mit abriebfesten Teilen, wie z.B. Aluminiumoxid, Siliziumkarbid und ähnliches angereichert sind, gefertigt werden.

Die in Position 72...83 dargestellten Friktionselemente 3 werden mit Hilfe von organischem Hochtemperaturkleber oder mittels leichtschmelzender Gläser auf die Multilayerplatte 2 aufgeschweißt.

Die in Position 72...83 dargestellten Friktionselemente 3 können auch aus hochtemperaturbeständigen Plastwerkstoffen, angereichert mit Teilen von harten abriebfesten Materials, gefertigt werden.

Die in den Positionen 84, 85 dargestellten Friktionselemente 3 werden durch Aufschmelzen eines abriebfesten Glases oder eines mit Teilen abriebfesten Materials angereicherten Glases auf die Multilayerplatte 2 hergestellt.

Position 86 zeigt das doppelschichtige Friktionselement 3. Die untere Schicht 87 des Friktionselementes wird aus einen Material, dessen Elastizitätsmodul und Temperaturausdehnungskoeffizient nah zum Elastizitätsmodul und dem Temperaturausdehnungskoeffizienten der Multilayerplatte 2 liegt, gefertigt. Dafür kann z.B. unpolarisierte Piezokeramik verwendet werden. Das Material der oberen Schicht 88 muss eine hohe Festigkeit und eine hohe Abriebfestigkeit aufweisen. Diese Schicht kann aus abriebfestem Glas, aus einer dünnen Schicht Oxidkeramik oder aus einer anderen harten abriebfesten Keramik hergestellt werden.

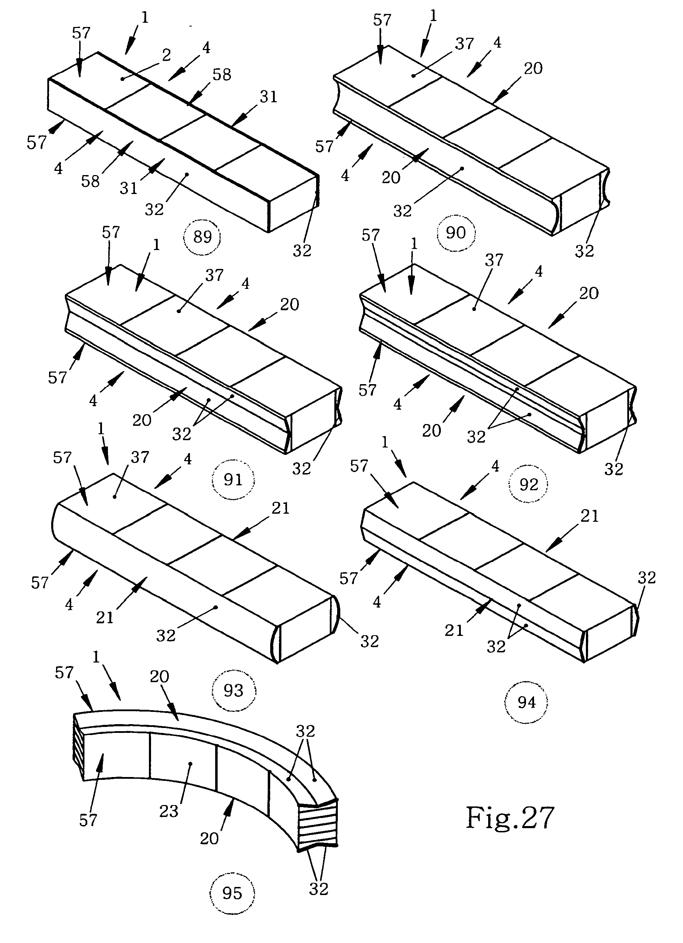

Die Positionen 89...95, in Abb. 27 zeigen weitere Varianten des Aktors 1, dessen Multilayerplatte 2, 37 oder 23 auf seinen Seitenflächen 4 die Friktionsschicht 32 aufweisen.

Diese Friktionsschicht 32 kann z.B. als dünnes Platte aus einem harten abriebfesten Material, wie z.B. Oxidkeramik, Metallkeramik, Glas oder eines mit Teilen abriebfesten Materials angereichertem Glas gefertigt werden. Außerdem kann die Schicht 32 eine dünne abriebfeste durch Aufdampfen oder Ausscheiden aus einem Gasmedium von Stoffen wie Ti, Cr, TiN, TiCN, TiC, CrN, TiAIN, ZrN, TiZrN, TiCrN oder C als Diamantpolykristalle erzeugte Platte darstellen. Die Friktionsschicht 32 kann eine dünne Graphitschicht oder eine Schicht Molybdändisulfat, die durch Reibung oder eine andere geeignete Methode auf die Oberfläche der Seitenflächen 4 des Aktors 4 aufgetragen wird, darstellen.

Bei dem in Position 89 gezeigten Aktor 1 befindet sich die Friktionsschicht 32 auf der ebenen Oberfläche 31 der Seitenflächen 4 der Platte 2. Bei den in den Positionen 90...95 gezeigten Aktoren 1 haben die Platten 37 auf ihren Seitenflächen 4 aufgebrachte Führungsriefen 20 oder Führungsschienen 21 mit runder, V-förmiger und trapezförmiger Form. In einer anderen Variante befinden sich die Führungsriefen 20 und Führungsschienen 21 auf der als dünne Platte ausgeführten Friktionsschicht 32. In einer weiteren Variante kann die Friktionsschicht 32 als auf die Oberfläche der Führungsriefen 20 oder der Führungsschienen 21 aufgetragene Schicht hergestellt werden, die damit Teil der Multilayerplatte 37 sind.

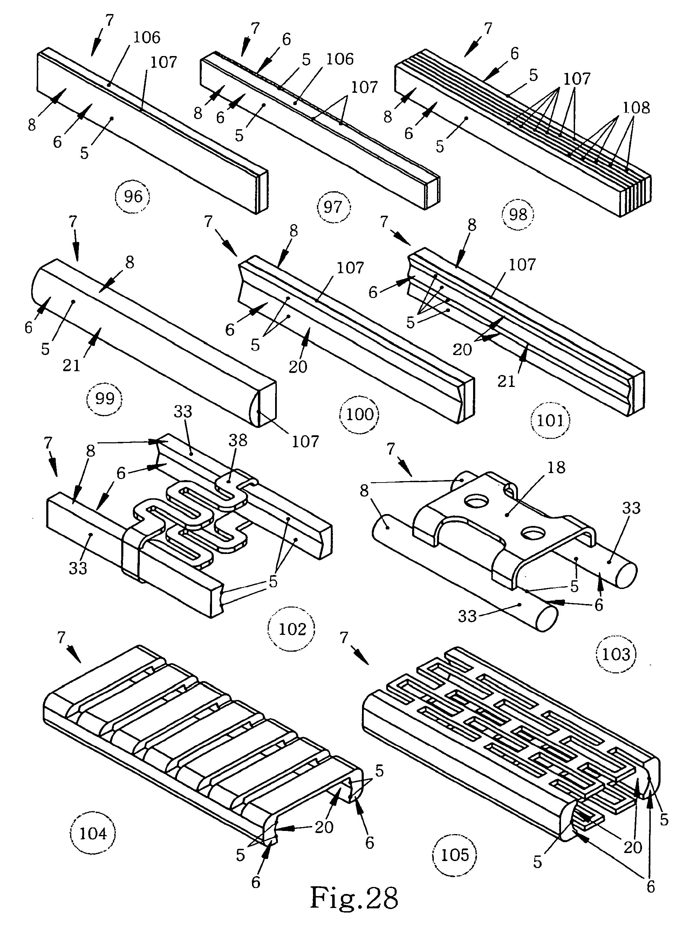

Die Positionen 96...105 in Abb. 28 zeigen einige der möglichen Varianten für die angetriebenen Elemente 7.

Die angetriebenen Elemente 7 können als Stäbe 8 (Position 96...97) ausgeführt werden, die aus einer elastische Halteplatte 106 und einer oder zwei abriebfesten Schichten 6 mit der Friktionsschicht 5 bestehen.

Die abriebfesten Schichten 6 können als dünne Platten aus festem abriebfestem Material, wie z.B. Oxidkeramik, Metallkeramik, Glas oder eines mit Teilen abriebfesten Materials angereicherten Glas oder aus harten abriebfesten Plastwerkstoffen gefertigt werden. Sie haben eine glatte Friktionsoberfläche 5 und werden mit Hilfe der dünnen schallisolierenden Schicht 107 mit der Halteplatte 106 verbunden.

Das angetriebene Element 7 kann eine Multilayerstruktur haben, in denen die dünnen schallisolierenden Schichten 107 abwechselnd mit den dünnen elastischen Platten 108 (Position 98) angeordnet sind.

Die abriebfesten Schichten 6 des angetriebene Elements 7 können eine Führungsschiene 21 (Position 99), eine Führungsriefe 20 (Position 100) oder abwechselnd angeordnete Führungsschienen 21 und Führungsriefen 20 (Position 101) aufweisen. Die Führungsschienen 21 und die Führungsriefen 20 können in runder, V-förmiger oder in einer anderen Form ausgeführt sein.

Die Positionen 102 und 103 in Abb. 28 zeigen zusammengesetzte angetriebene Elemente 7. Diese angetriebenen Elemente 7 haben zwei Stäbe 8, die durch die Federn 38 oder 18 zusammengehalten werden. Die Stäbe 8 dieser angetriebenen Elemente 7 können aus harten abriebfesten Plastwerkstoffen mittels Spritzgussverfahren gefertigt werden. Die Federn 38, 18 können beim Gießen der Stäbe 8 in deren Körper eingeschlossen werden.

Die Positionen 104, 105 in Abb. 28 zeigen Varianten monolithischer angetriebener Elemente 7, die vollständig aus Plastwerkstoffen - z.B. im Spritzgussverfahren - hergestellt werden.

In dem einen wie auch dem anderem Fall sind Plastwerkstoffe gut geeignet, bei denen teilkristallisiertes Polyacrylamid die Basis bildet, angereichert mit einer Glasphase mit Aluminuimoxidteilen oder Teilen eines anderen abriebfesten Materials.

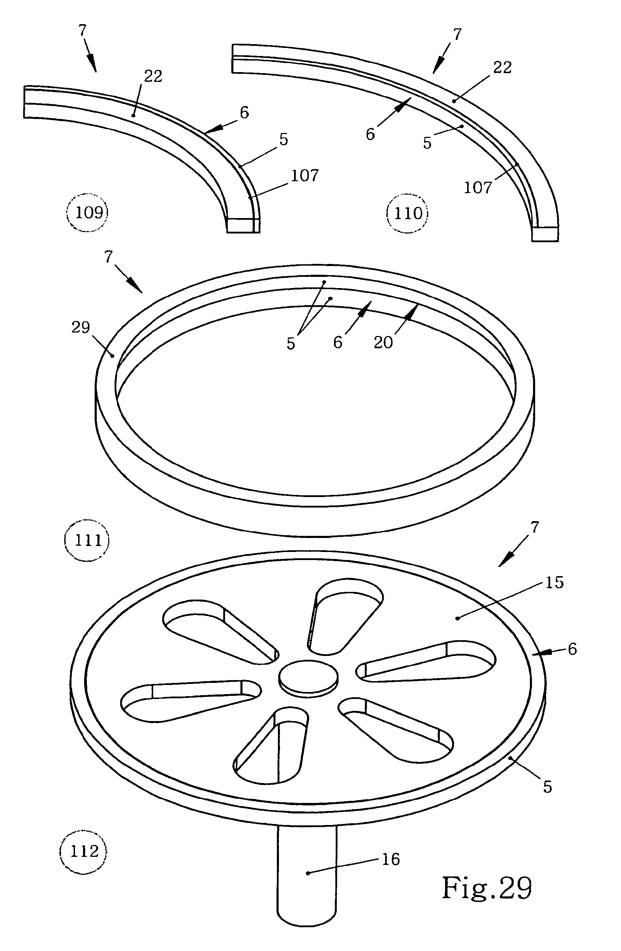

Die Positionen 109, 110, 11, 112 in Abb. 29 zeigen angetriebene Elemente, ausgeführt als Teile des Rings 22, als Ring 29 und als Scheibe 15.

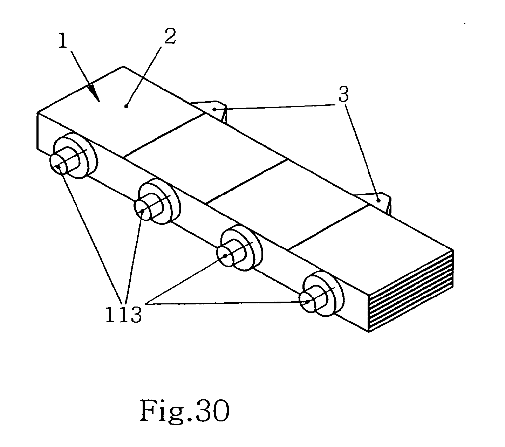

Abb. 30 zeigt einen Aktor 1, eine Multilayerplatte 2 mit den Haltelementen 113.

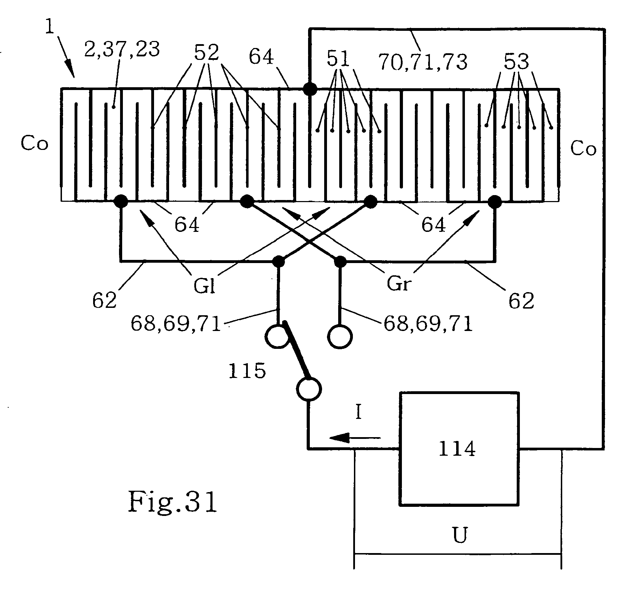

Abb. 31 zeigt die elektrische Schaltung, die den Aktor 1 mit der elektrischen Erregervorrichtung 114 verbindet. Die Schaltung besitzt einem Umschalter für die Generatoren 115. Die elektrische Erregervorrichtung 114 stellt eine sinusförmige Erregerspannung U mit der Frequenz ωₒ bereit. Aufgrund dieser Spannung fließt durch den Aktor 1 der sinusförmige Strom I. Zwischen den Erregerelektroden 51 und den allgemeinen Elektroden 52 bildet sich die elektrische Kapazität Cₒ aus, die zugleich die Eingangskapazität des Aktors 1 darstellt.

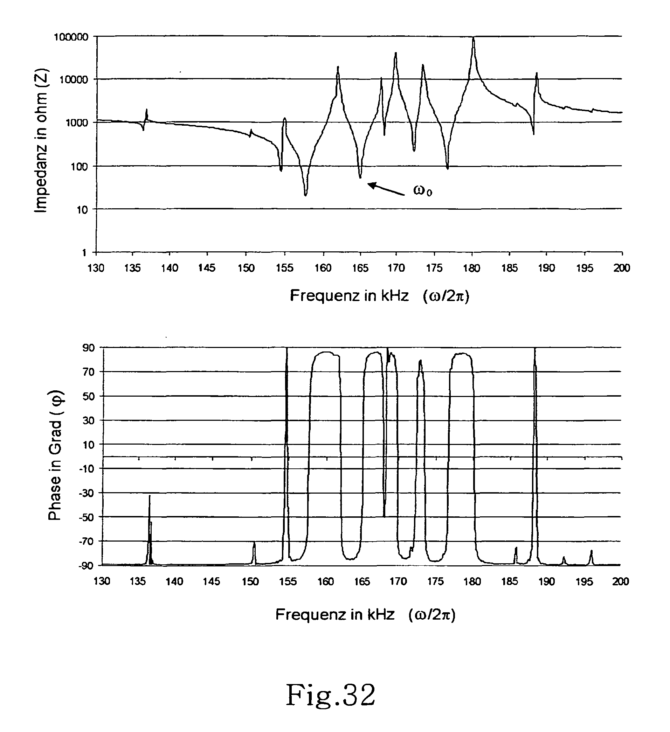

Abb. 32 zeigt die Frequenzabhängigkeit der elektrischen Impedanz Z des Generators GI oder Gr des Aktors 1 (Position 116) und die Frequenzabhängigkeit der Phasenverschiebung ϕ zwischen der Erregerspannung U und den durch den Aktor 1 (Position 117) fließenden Strom I. Die Abhängigkeiten gelten für den als rechtwinklige Platte 2 ausgeführten Aktor 1 mit den Abmessungen L=₅₀ mm, H=10,5 mm, T=4 mm. Dabei stellt ωₒ die Betriebsfrequenz des Aktors 1 dar.

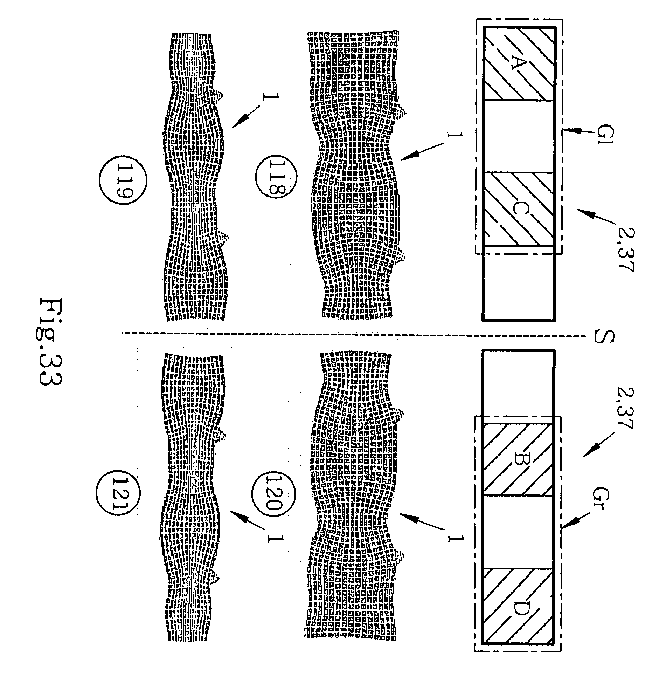

Abb. 33 zeigt Bilder der maximalen Deformation der Platte 2, bei der ωₒ die Betriebsfrequenz des Aktors 1 ist. Die Positionen 118, 119 zeigen Bilder der Deformation der Platte 2 bei Ansteuerung durch den Generator GI. Die Positionen 120, 121, zeigen Bilder der Deformation der Platte 2 bei Ansteuerung durch den Generator Gr.

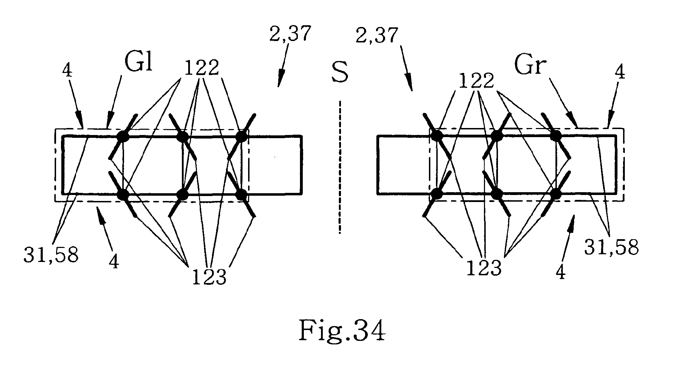

Abb. 34 zeigt die Bewegungsbahnen 122 der Materialpunkte 123, die sich auf den Oberflächen 31 (58) und 59 der Platte 2 bei Ansteuerung durch den Generator GI (Position 124) und bei Ansteuerung durch den Generator Gr (Position 125), befinden.

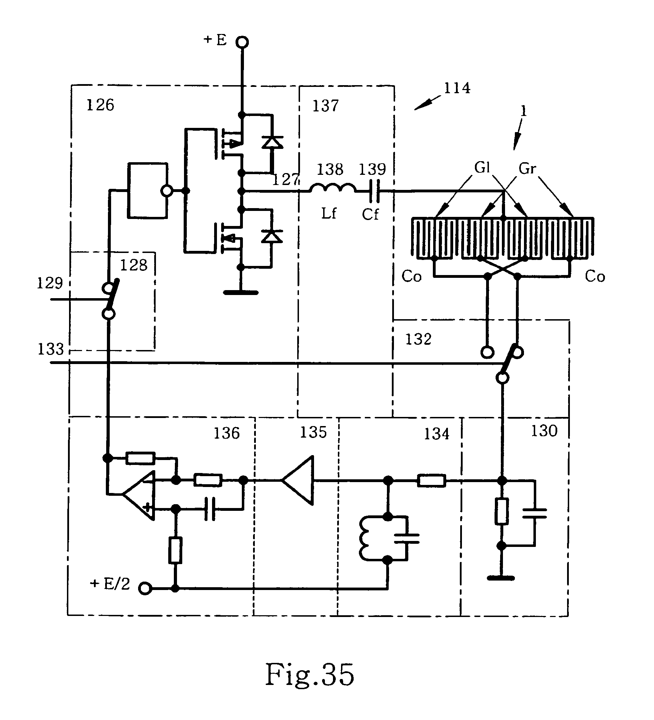

Abb. 35 zeigt die Blockschaltung der elektrischen Erregervorrichtung 114 des Aktors 1, einschließlich weiterer elektrischer Bauteile. Die Blockschaltung besteht aus dem Impuls-Leistungsverstärker 126 mit dem Ausgang 127, dem Ausschalter 128 mit dem Steuereingang 129, dem Rückkopplungselement 130, dem Rückkopplungskreis 131 und dem steuerbaren Umschalter 132 mit dem Steuereingang 133.

Der Leistungsverstärker 126 kann als Halbbrückenverstärker (siehe Abb. 35) oder Brückenverstärker ausgeführt werden. Wenn ein Brückenverstärker verwendet wird, muss ein Anpassungsübertrager eingesetzt werden (in den Abb. nicht dargestellt). Der Rückkopplungskreis 131 kann aus dem Spannungsfilter 134, dem Verstärker des Rückkopplungskreises 135, den Phasenschieber 136 bestehen.

Der Aktor 1 wird über das Ausgangsfilter 137, bestehend aus der Induktivitätsspule 138 mit der Induktivität L_{f} und dem Kondensator 139 mit der Kapazität C_{f} mit dem Ausgang 127 des Verstärkers 126 verbunden.

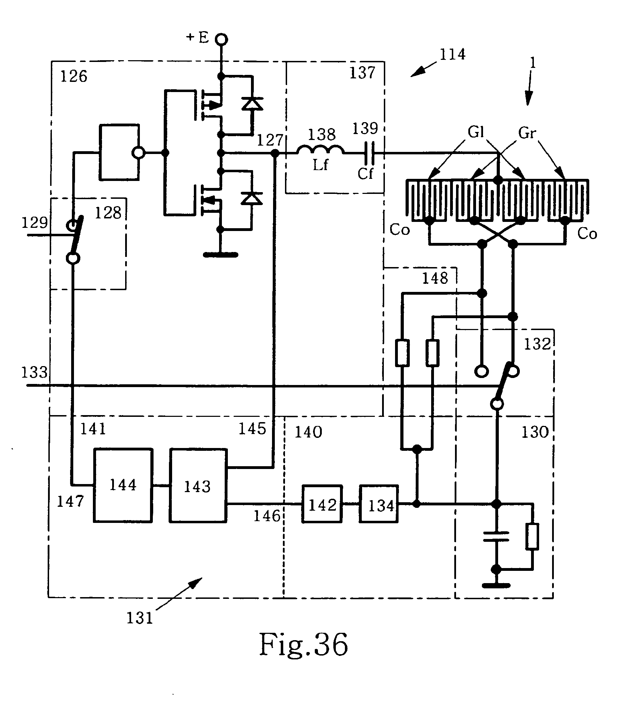

Die Abb. 36 zeigt eine weitere Variante für die elektrische Erregervorrichtung 114. In dieser Variante besteht der Rückkopplungskreis 131 aus dem Impulsformer für Rechteckspannungen 140 und dem Phasendetektor 141. Der Impulsformer 140 besteht aus dem Spannungsfilter 134 und dem Komperator 142. Der Phasendetektor 141 besteht aus dem Wandler der Phasenverschiebung in eine Steuerspannung 143 und dem spannungsgesteuertem Generator 144. Der Phasendetektor 141 besitzt den Stützeingang 145, den Phaseneingang 146 und den Ausgang 147.

In dieser Variante wird der Rückkopplungskreis 131 direkt mit dem Rückkopplungselement 130 verbunden oder er kann auch über die Trennwiderstände 148 - wie in Abb. 36 gezeigt - mit den Erregerelektroden 51 verbunden werden.

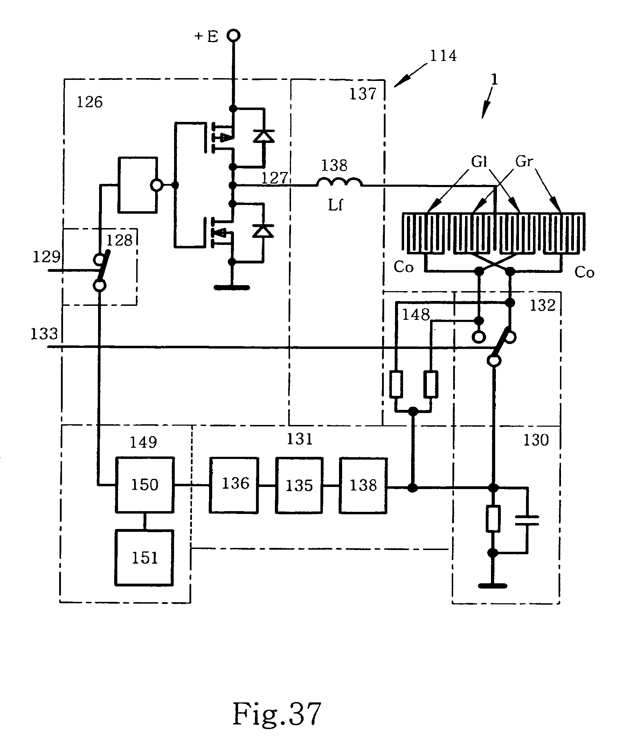

Abb. 37 zeigt eine weitere Variante für die Erregervorrichtung 114. Diese Erregervorrichtung besteht aus dem PWM-Modulator für die Rückkopplungsspannung 149. Der Modulator 149 besteht aus dem Modulationselement 150 und dem Dreiecksspannungsgenerator 151.

Die in Abb. 35 dargestellte Variante der elektrischen Erregervorrichtung 114 besteht aus dem Linear-Leistungsverstärker 152 und dem Kompensationsspule 153, die parallel zum Multilayeraktor 1 geschaltet ist. Die Kompensationsspule 153 besitzt die Induktivität Lₖ. Sie ist mit dem Ausgang 127 des Linear-Leistungsverstärkers 152 über den Trennkondensator 154, der die Kapazität Cₜ besitzt, verbunden.

Der vorgeschlagene Ultraschallmotor funktioniert folgendermaßen. Sobald an den Erregerelektroden 52 und den allgemeinen Elektroden 51 die vom Generator GI oder Gr erzeugte sinusförmige Spannung U (siehe Abb. 31), deren Frequenz gleich ωₒ ist (siehe Abb. 32), anliegt, wird in dem Multilayeraktor 1 eine zweidimensionale (ebene) asymmetrische akustische Stehwelle erzeugt (siehe Abb. 33). Die Frequenz ωₒ ist dabei die Resonanzfrequenz, bei der eine solche Welle erzeugt wird. Die Anregung der Welle erfolgt durch die aktiven Zonen A, C oder B, D des Generators GI oder des Generators Gr (siehe Abb. 16...21,23). Die Länge L des Aktors 1 bestimmt die Länge der erregten asymmetrischen Welle.

Da jede aktive Zone A, C oder C, D des Generators GI oder des Generators Gr aus abwechselnd angeordneten Schichten der Elektroden 51, 52 und der dünnen piezokeramischen Schichten 53 zwischen ihnen besteht (siehe Abb. 20, 21, 22, 31), sind für eine maximale Deformation des Aktors 1 nur niedrige Erregerspannungen erforderlich. Außerdem wird der Aktor 1 über das gesamte Volumen erregt, wobei das elektrische Feld im inneren des Aktors 1 konzentriert ist und nicht nach außen gelangt.

In jeder der aktiven Zonen A, C oder B, D können die Erregerschichten 51, die allgemeinen Elektroden 52 und die piezokeramischen Schichten 53 zwischen ihnen, wie in den Positionen 54, 55, 56 der Abb. 20, 21, 22 dargestellt, angeordnet sein. Die verschiedenartige Anordnung der Schichten ermöglicht es, die Effektivität der Erregung der asymmetrischen Stehwelle zu ändern, wodurch die Höhe der Erregerspannung U in Richtung des Bereichs niedrigerer Spannungswerte geändert wird.

Beim Auftreten einer asymmetrischen Stehwelle bewegen sich die auf der Oberfläche 31 (58), 59 der Multilayerplatte 1 liegenden Materialpunkte 123 auf den in Abb. 34 dargestellten linearen Bewegungsbahnen.

Die erregte asymmetrische Stehwelle weist charakteristische Merkmale auf, die sie von den anderen Formen asymmetrischer Stehwellen unterscheidet. So besitzt sie drei Maxima für die Schwingungsgeschwindigkeiten: ein zentrales Maximum und zwei Seitenmaxima. Das zentrale Maximum befindet sich im Zentrum der Platte 2. Die Seitenmaxima befinden im Abstand von etwa ¼ L von den Stirnflächen 59, bezogen auf die Mittelinie der Platte 2. Die Bewegungsbahnen 122 der Materialpunkte 123, die sich im zentralen Maximum befinden, sind zur Oberfläche 31 (58) geneigt und zwar entgegengesetzt zu den Bewegungsbahnen 122 der Materialpunkte 123, die sich in den Seitenmaxima befinden.

Die beschriebene Welle wurde in den bekannten Ultraschallmotoren mit Multilayeraktor bislang nicht verwendet.

Im vorgeschlagenen Motor werden die Friktionselemente 3 in den Stellen der zentralen Maxima oder in den Stellen der Seitenmaxima der Platte 2 des Aktors 1, wie in Abb. 1...12, 30 dargestellt, angeordnet. Bei elektrische Anregung durch den Generator GI oder den Generator Gr bewegen sich (schwingen) die Friktionselemente 3 auf zu den Friktionsoberflächen 5 geneigten Bewegungsbahnen, in Analogie zu den Bewegungsbahnen 122.

Der Bewegungsmechanismus des angetriebenen Elementes 7 kann wie folgt erläutert werden. Bei Verschiebung des Friktionselementes 3 in Richtung der Friktionsoberfläche 5 verklebt / verkeilt sich dieses mit der Friktionsoberfläche 5 und schiebt so diese voran. Das veranlasst das angetriebene Element 7, sich in Richtung der Neigung der Bewegungsbahn 122 zu bewegen. Bei Verschiebung des Friktionselements 3 in Richtung weg von der Friktionsoberfläche 5, löst es sich und das angetriebene Element 7 erhält die Möglichkeit, sich aufgrund der Trägheit zu bewegen.

In den Motoren, bei denen die Platte 2, 37 des Aktors 1 mit einer Friktionsschicht 32 (siehe Abb. 13...14, 24, 25 Position 67, Abb. 27) versehen ist, erklärt sich der Bewegungsablauf des angetriebenen Elementes durch das Zusammenwirken aller schwingenden Materialpunkte der Friktionsschicht 32 auf der Friktionsoberfläche 5 des angetriebenen Elementes 7.

Motoren, in denen der Aktor 1 einen Teil des Ringes 23 bildet, arbeiten analog zu den Motoren, bei denen der Aktor 1 als rechtwinklige Platte 2 ausgeführt ist. Das erklärt sich dadurch, dass der Aktor 1 als Teil des Ringes 23 eine kleine Krümmung aufweist. Diese Krümmung wird durch den Radius r bestimmt, der so gewählt wird, dass er etwa gleich ½ L ist (siehe Abb. 16, Position 40).

Die Bewegungsgeschwindigkeit des angetriebenen Elementes 7 und die erzeugte Kraft hängen vom Neigungswinkel der Bewegungsbahn des Friktionselementes 3 zur Friktionsoberfläche 5 der abriebfesten Schicht 6 des angetriebenen Elementes 5 ab. Dieser Winkel wird durch das Verhältnis der Länge L der Platte 2 - bezogen auf die Mittellinie - zur Höhe H bestimmt.

Bei der Erprobung von Mustermotoren zeigte sich, dass diese Motoren ihre maximale Geschwindigkeit und ihre maximale Kraft bei einem Verhältnis von L/H=4,75 entwickeln. Die Erprobungen erfolgten mit Aktoren mit einer Platte mit folgenden Abmessungen L=₅₀ mm, H=10,5 mm und T= 4 mm. Die Platte wurde aus Piezokeramik des Typs PIC 181 gefertigt. Das optimale Verhältnis von L/H kann bei verschiedenen Längen L der Platte und bei verschiedenen Typen von Piezokeramik variieren.

Die Betriebsfrequenz des Aktors 1 kann gemäß der Formel ωₒ=N/L bestimmt werden, wobei N die Frequenzkonstante der erregten asymmetrischen Welle darstellt. Für den aus Piezokeramik des Typs PIC 181 hergestellten Aktor 1 beträgt die Frequenzkonstante 8250 Hz m.

In dem vorgeschlagenen Motor hat die Multilayerplatte 2 (37, 23) des Aktors 1 zwei spiegelbildlich angeordnete asymmetrische Generatoren für Ultraschallschwingungen GI und Gr (siehe Abb. 18, 19). Durch diese Konstruktion des Aktors 1 ist es möglich, unabhängig im Aktor 1 mit Hilfe eines der Generatoren (GI oder Gr) eine asymmetrische Stehwelle zu erzeugen, die ein Spiegelbild der Welle ist, die durch den zweiten Generator (Gr oder GL) erzeugt wurde (siehe Abb. 33, 34).

Diese Eigenschaft der Generatoren macht es möglich, den Neigungswinkel der Bewegungsbahn 122 der Materialpunkte 123, die sich auf der Oberfläche 32 (58), 24, 25 der Platte 2, 23, 37 befinden, umzukehren und dadurch den Neigungswinkel der Bewegungsbahnen der Friktionselemente 3 oder der Bewegungsbahnen der Punkte der Friktionsschichten 32 zu ändern. Die Änderung des Neigungswinkels erfolgt durch einfaches Umschalten der Generatoren GI und Gr mit Hilfe des Umschalters 115 oder 132. Dabei ändert die erzeugte asymmetrische Welle seine Form spiegelbildlich (siehe Abb. 33, 34). Die Umkehrung des Neigungswinkels der Bewegungsbahn 122 ermöglicht es, die Richtung der Bewegung des angetriebenen Elements 7 zu ändern. Dabei behält der Motor seine Bewegungsparameter - Geschwindigkeit und entwickelte Kraft - bei.

Diese Eigenschaft wird erfüllt durch den Aktor 1 mit einem oder zwei Friktionselementen 3 auf einer seiner Seitenflächen (siehe Abb. 1, 2, 4, 5, 7...12), mit zwei oder vier Friktionselementen 3 auf seinen zwei gegenüberliegenden Seitenflächen (siehe Abb. 3, 6) und durch einem Aktor 1 mit Friktionsschichten 32 (siehe Abb. 13, 14, 15, 24, 27).

Die vorgeschlagene Erfindung berücksichtigt auch andere Plattenformen für den Aktor 1, die sich von den bisher beschriebenen Formen unterscheiden, durch die es möglich ist, unabhängig im Aktor 1 mit Hilfe eines (GI oder Gr) der Generatoren eine asymmetrische Stehwelle zu erzeugen, die das Spiegelbild der durch den zweiten Generator (Gr oder GI) erzeugten Welle darstellt. Für den effektiven Betrieb des vorgeschlagenen Ultraschallmotors ist es wichtig, die Frequenz der Erregerspannung U gleich der Resonanzfrequenz der zweidimensionalen asymmetrischen akustischen Stehwelle zu halten, die gleich der Betriebsfrequenz ωₒ des Aktors 1 ist. Da die Resonanzfrequenz der erzeugten zweidimensionalen asymmetrischen akustischen Stehwelle sich in Abhängigkeit von der Umgebungstemperatur und der an dem angetriebenen Element 7 anliegenden Last etwas ändert, muss die elektrische Erregervorrichtung dieser Änderung folgen, sie ausgleichen.

Dafür ist in der vorgeschlagenen Erfindung die elektrische Erregervorrichtung 114 als selbsterregender Generator ausgeführt, dessen Erregerfrequenz durch die Resonanzfrequenz des mit ihm verbundenen Multilayeraktors 1 vorgegeben wird (siehe Abb. 35).

Zur Realisierung in der elektrischen Erregervorrichtung wird dabei die Frequenzabhängigkeit der Phasenverschiebung des durch den Aktor 1 fließenden Stromes I, bezogen auf die Erregerspannung U, ausgenutzt. Diese Abhängigkeit besitzt nur eine nah zur mechanischen Resonanz des Aktors 1

(siehe Abb. 31, 32), d.h. nah zur Frequenz ωₒ, liegende Null-Phasenverschiebung.

Diese elektrische Erregervorrichtung 114 funktioniert folgendermaßen. Beim Anlegen der Versorgungsspannung E fließt durch den Aktor 1 ein Stromimpuls, wodurch er auf seinen Resonanzfrequenzen zu schwingen beginnt. Im Ergebnis dessen, bildet sich auf dem Rückkopplungselement 130 eine Rückkopplungsspannung aus, die proportional zum durch den Aktor 1 fließenden Strom ist, der das Rückkopplungssignal darstellt. Die Spannung gelangt auf den Eingang des Rückkopplungskreises 131, wo sie durch das Filter 134 gefiltert wird. Das Filter filtert die erste Harmonische dieser Spannung heraus, die der Betriebsfrequenz ωₒ des Aktors 1 entspricht. Anschließend wird die Spannungsamplitude durch den Verstärker 135 verstärkt und die Phase durch den Phasenschieber 136 verschoben.

Danach wird die Spannung auf den Eingang des Leistungsverstärkers 126 geleitet, wird durch ihn verstärkt und gelangt von seinem Ausgang 127 über das Filter 137 auf den Aktor 1. Die Schaltung wird so ausbalanciert, dass bei der Betriebsfrequenz ωₒ der Phasenverschiebungswinkel im geschlossenen Rückkopplungskreis gleich Null und der Verstärkungskoeffizient größer eins ist. Deshalb stellt die in Abb. 35 abgebildete elektrische Erregervorrichtung 114 einen selbsterregenden Generator dar, der auf der Frequenz ωₒ schwingt. Das Ausbalancieren der Schaltung erfolgt mit dem Phasenschieber 136 und dem Verstärker 135 des Rückkopplungskreises 131. Nach dem Anlegen der Versorgungsspannung E oder dem Schließen des Ausschalters 128 schwingt die Einrichtung eigenständig auf der Frequenz ωₒ.

Es kann auch ein anderes Prinzip zur Anwendung kommen, um die Betriebsfrequenz der Erregervorrichtung 114 gleich der Frequenz ωₒ zu halten. Dabei besteht der Rückkopplungskreis 131 aus dem Impulsformer für Rechteckspannung 140 und den Phasendetektor 141. Der Impulsformer 140 besteht aus dem Filter 134 und dem Komperator 142. Der Phasendetektor 141 enthält, wie in Abb. 36 gezeigt, den Wandler der Phasenverschiebung in eine Steuerspannung 143 und den spannungsgesteuerten Generator 144.

Diese elektrische Erregervorrichtung arbeitet folgendermaßen. Beim Anlegen der Versorgungsspannung E beginnt der Generator 144 auf einer Frequenz nah zur Frequenz ωₒ zu schwingen. Zu Beginn schwingt der Aktor 1 auf dieser Frequenz. An dem Rückkopplungselement 130 oder an der Erregerelektrode (freie Elektrode) 51 bildet sich die Rückkopplungsspannung aus. Diese Spannung gelangt über das Filter 134 auf den Komperator 142. Der Komperator 142 erzeugt eine Rechteckspannung, die auf den Phaseneingang (Messeingang) 146 des Phasendetektors 141 gelang. Am Stützeingang 145 des Detektors 141 liegt die rechteckige Stützspannung an.

Demzufolge liegen an den Eingängen 145 und 146 die zwei Rechteckspannungen der Phasenverschiebung an, durch die die Höhe der an dem Ausgang des Wandlers 143 anliegenden Steuerspannung bestimmt wird. Diese Spannung wird auf den Eingang des Generators 144 geleitet und steuert dort über die Frequenz die Erregung des Generators und zwar so, dass sie diese so verschiebt, dass sie ständig gleich der Frequenz ωₒ ist.

In dieser Variante kann der Phasendetektor 141 sowohl durch einzelne elektronische Bauelemente als auch durch einen programmgesteuerten Mikroprozessor realisiert werden. Außerdem kann der Phasendetektor 141 auch durch Bauelemente mit fest verdrahteter Logik realisiert werden.

Im ersten und im zweiten Fall stellt das Ausgangsfilter 137 ein auf die Frequenz ωₒ abgestimmtes Bandpassfilter dar. Es dient zur Filterung der ersten Harmonischen aus der vom Leistungsverstärker 126 bereitgestellten Rechteckspannung, dessen Frequenz gleich ωₒ ist. Die Kapazität des Kondensators 130 dieses Filters wird so ausgewählt, dass die Bedingung, dass sie gleich oder ein wenig größer als die Eingangskapazität Cₒ des Multilayeraktors 1 zu sein, erfüllt wird. Dadurch ist es möglich, die erforderliche Güte des Filters zu erreichen.

Abb. 37 zeigt eine weitere Variante der elektrischen Erregervorrichtung 114. Die elektrische Erregervorrichtung besteht dabei aus dem symmetrischen PWM-Modulator 149 für die Rückkopplungsspannung. Der Modulator 149 besteht aus dem Modulationselement 150 und dem Dreiecksspannungsgenerator 151, dessen Frequenz etwa 10-mal größer als die Frequenz ωₒ ist. Als Modulationselement 150 kann ein Operationsverstärker oder ein Komperator verwendet werden.

Mit Hilfe des Modulators 149 wird die sinusförmige Rückkopplungsspannung durch die hochfrequente Dreiecksspannung moduliert. Dadurch steht am Ausgang des Modulators 149 eine symmetrische PWM-modulierte Rechteckspannung bereit, deren Impulsfolgefrequenz etwa 10-mal größer als die Frequenz ωₒ ist. Diese Spannung wird auf den Eingang des Leistungsverstärkers 126 gegeben, wo sie durch ihn verstärkt wird.

Dadurch gelangt die rechteckige PWM-Spannung, deren Impulsfolgefrequenz etwa 10-mal größer als die Frequenz ωₒ ist, auf den Eingang des Filters 137. Das Spannungsspektrum enthält Komponenten, deren Frequenz gleich ωₒ ist. Zur Selektion dieser Komponente kann die Induktivität L_{f} der Spule 138 des Filters 137 bedeutend kleiner (etwa 5...10 mal kleiner) als bei den vorherigen Varianten gewählt werden. Als Kondensator 139 für das Filter 137 kann die Eingangskapazität Cₒ des Aktors 1 (siehe Abb. 37) genutzt werden. In diesem Fall wird das Filter 137 auf eine Frequenz zwischen ωₒ und 10ωₒ abgestimmt. Dadurch ist es möglich, den aktiven Widerstand der Induktivitätsspule 138 bedeutend zu reduzieren, d.h. die Energieverluste im Eingangsfilter 137 werden bedeutend gesenkt. Dies erhöht den Wirkungsgrad der elektrischen Erregervorrichtung 114.

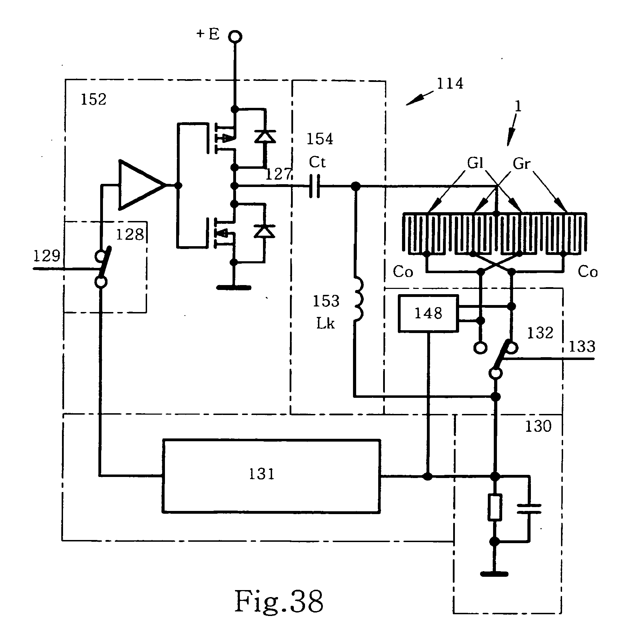

Wenn ein Linear-Leistungsverstärker 152 zum Einsatz kommt, kann - wie in Abb. 38 dargestellt - parallel zum Multilayeraktor 1 eine Kompensationsspule 153 geschaltet werden. Die Größe der Induktivität wird unter Beachtung der Bedingung ωₒ Lₖ=1/ ωₒ Cₒ ausgewählt. Dabei wird Cₜ so gewählt, dass sie bedeutend größer Cₒ ist.

Dadurch ist es möglich, die elektrische Kapazität Cₒ zu kompensieren und die Betriebsstabilität des Linear-Leistungsverstärkers 152 und damit die des Motors insgesamt wesentlich zu erhöhen.

In dem erfindungsgemäß ausgeführten Ultraschallmotor ist das Verhältnis von Länge L des Multilayeraktors zur Höhe H etwa 2-mal größer als bei dem Aktor nach der DE 10 2005 039 358 A1. Deshalb hat der erfindungsgemäße Motor mit einem Friktionselement auf dem Aktor bei gleicher Höhe H eine zweifach höhere mechanische Leistung. Anderseits kann bei gleicher mechanischer Leistung die Höhe des Multilayeraktors zweimal kleiner im Vergleich zur DE 10 2005 039 358 A1 gehalten werden.

Dies erweitert die funktionellen Einsatzmöglichkeiten des erfindungsgemäßen Ultraschallmotors.

Im vorgeschlagenen Motor können auf einer Seite des Multilayeraktors zwei Friktionselemente angeordnet werden. Dies erhöht wesentlich die mechanische Stabilität des Multilayeraktors. Ein solcher Aktor ändert auch bei beliebigen auf dem angetriebenen Element 7 anliegenden mechanischen Beanspruchungen nicht seine Winkellage. Dies erhöht wesentlich die Stabilität der Zugkraft des Motors und erhöht die Konstanz der Bewegungsgeschwindigkeit des angetriebenen Elementes 7. Das eine wie auch das andere ermöglicht es, die Positioniergenauigkeit des angetriebenen Elementes 7 im Bereich der maximalen Zugkraft des Motors zu erhöhen.

Der Mulitayeraktor des vorgeschlagenen erfindungsgemäßen Motors besitzt einen optimalen Neigungswinkel der Bewegungsbahnen in einem zweimal größeren (günstigeren) Verhältnis der Länge L zur Höhe H als im Fall des Multilayeraktors nach DE 10 2005 039 358 A1. Bei dem Multilayeraktor nach DE 10 2005 039 358 A1 ist das Verhältnis von Länge L zur Höhe H nicht optimal. Deshalb zeichnet sich der vorgeschlagene erfindungsgemäße Motor durch einen bedeutend geringeren Abrieb des Friktionskontaktes und folglich eine größere Standzeit im Vergleich zum Motor nach DE 10 2005 039 358 A1 bei gleichen geometrischen Abmessungen des Multilayeraktors aus. Er hat einen geringeren Geräuschpegel.

Da im Aktor des vorgeschlagenen Motors eine zweidimensionale akustische Stehwelle und keine Biegewelle erzeugt wird, kann der erfindungsgemäß ausgeführte Motor mit einem mechanisch steiferen angetriebenen Element ausgestattet werden. Deshalb hat ein solcher Motor eine höhere mechanische Leistung als die Motoren entsprechend den Patenten US 6,081,063; US 7,205,703 B2; US 7,211,929 B2; US 2007/0108869 A1.

Da der Multilayeraktor des vorgeschlagenen Ultraschallmotors nur eine nah zur Betriebsfrequenz liegende Resonanzstelle aufweist, ist es möglich, die Frequenz der elektrischen Erregervorrichtung eindeutig so zu steuern, dass sie gleich der Betriebsfrequenz des Aktors gehalten werden kann. Dies erhöht die Betriebsstabilität des erfindungsgemäß ausgeführten Ultraschallmotors in einem breiten Temperaturbereich und bei hohen anliegenden Lastkräften. Im Verhältnis zu den bekannten Motoren nach den Patenten US 6,081,063; US 7,205,703 B2; US 7,211,929 B2; US 2007/0108869 A1 funktioniert der vorschlagsgemäß ausgeführte Motor stabiler bei Änderungen der Temperatur und bei hohen anliegenden Zugkräften.

### Bezugszeichenliste

- 1.: Multilayerultraschallaktor
- 2.: Rechtwinklige Multilayerplatte des Aktors 1
- 3.: Friktionselement des Aktors 1
- 4.: Seitenfläche des Aktors 1
- 5.: Friktionsoberfläche der abriebfesten Schicht 6
- 6.: Abriebfeste Schicht des angetriebenen Elements 7
- 7.: Angetriebenes Element
- 8.: Stab des angetriebenen Elements 7
- 9.: Lager
- 10.: Grundplatte
- 11.: Anpressvorrichtung
- 12.: Blattfeder der Anpressvorrichtung 11
- 13.: Isolierhülse
- 14.: Halteelement
- 15.: Als Scheibe ausgeführtes angetriebenes Element 7
- 16.: Achse
- 17.: Widerlager
- 18.: U-förmige Feder der Anpressvorrichtung 11
- 19.: Führungsstab
- 20.: Führungsriefe
- 21.: Führungsschiene
- 22.: Als Teil eines Ringes ausgeführtes angetriebenes Element 7
- 23.: Multilayeraktor 1 als Multilayerplatte in Form eines Teil eines Ringes
- 24.: Innere Zylinderoberfläche des Aktors 1 als Teil des Ringes 23
- 25.: Äußere Zylinderoberfläche des angetriebenen Elementes 7 als Teil des Ringes 23
- 26.: Elastisches (federndes) Element
- 27.: Äußere Zylinderoberfläche des Aktors 1 als Teil des Ringes 23
- 28.: Innere Zylinderoberfläche des angetriebenen Elementes 7 als Teil des Ringes 23
- 29.: Angetriebenes Element 7, ausgeführt als Ring
- 30.: Innere Oberfläche des angetriebenen Elementes 7, ausgeführt als Ring 29
- 31.: Ebene Oberflächen der Seitenflächen 4 der Platte 2
- 32.: Friktionsschicht
- 33.: Stößel des angetriebenen Elementes 7
- 34.: Friktionsplatten des angetriebenen Elementes 7
- 35.: Zweidimensionale (flache) Formfeder der Anpressvorrichtung 11
- 36.: Stifte der Stößel 33
- 37.: Myltilayerplatte des Aktors 1 mit Führungsriefen 20 oder Führungsschienen 21
- 38.: Dreidimensionale (volumetrische) Formfeder der Anpressvorrichtung 11
- 39...50.: Abbildungen mit Zeichnungen der Multilayerplatte 2, 37, 23 des Aktors 1
- 51.: Schicht der Erregerelektroden oder die Erregerelektrode
- 52.: Schicht der allgemeinen Elektrode oder die allgemeine Elektrode
- 53.: Piezokeramische Schichten.
- 54...56.: Abbildungen mit Zeichnungen der Multilayerplatte 2, 34 des Aktors 1
- 57.: Hauptflächen der Platte 2, 37, 23 des Aktors 1
- 58.: Oberflächen der Seitenflächen 4 der Platte 2, 37, 23 des Aktors 1
- 59.: Stirnflächen der Platte 2, 37
- 60, 61.: Abbildungen, die die Polarisationsrichtungen der piezokeramischen Schichten 53 angeben
- 62.: Verbindungselektrode
- 63.: Vorsprung der Elektroden 48, 49
- 64.: Kontaktfläche
- 65, 66, 67.: Abbildungen von Varianten stromführender Leiter
- 68.: Kabel, eingesetzt als stromführende Leiter
- 69.: Blattfeder, eingesetzt als stromführender Leiter
- 70.: Abstandshalter aus stromleitendem Gummi
- 71.: Als stromführender Leiter eingesetzte elastische Lamelle
- 72...86.: Abbildungen von Varianten der Friktionselemente 3
- 87.: Untere Schicht des Friktionselementes 86
- 88.: Obere Schicht des Friktionselementes 86
- 89...95.: Abbildungen von Varianten des Aktors 1
- 96...105.: Abbildungen von Varianten der angetriebenen Elemente 7
- 106.: Halteplatte
- 107.: Schallisolierende Schicht
- 108.: Dünne elastische Platten
- 109...112.: Abbildungen mit Varianten der angetriebenen Elemente 7
- 113.: Haltelemente
- 114.: Vorrichtung zur elektrischen Erregung der Generatoren für Ultraschallschwingungen
- 115.: Umschalter der Generatoren für Ultraschallschwingungen
- 116,117.: Abbildungen mit den Frequenzabhängigkeiten von Induktivität und Phasenverschiebung
- 118, 119, 120, 121.: Abbildungen mit den Darstellungen der Deformation der Platte 2
- 122.: Bewegungsbahnen der Materialpunkte 123
- 123.: Materialpunkte auf den Oberflächen 31 (58), 59 der Platte 2
- 124, 125.: Abbildungen mit den Darstellungen der Bewegungsbahnen 122
- 126.: Impuls-Leistungsverstärker
- 127.: Ausgang des Leistungsverstärkers 126
- 128.: Ausschalter
- 129.: Steuereingang des Ausschalters 128
- 130.: Rückkopplungselement
- 131.: Rückkopplungskreis
- 132.: Steuerbarer Umschalter der Ultraschallgeneratoren
- 133.: Steuereingang des Umschalters 132
- 134.: Spannungsfilter des Rückkopplungskreises
- 135.: Spannungsverstärker des Rückkopplungskreises
- 136.: Phasenschieber der Rückkopplungskreises
- 137.: Ausgangsfilter
- 138.: Induktivitätsspule des Filters 137
- 139.: Kondensator des Filters 137
- 140.: Impulsformer für Rechteckspannung
- 141.: Phasendetektor
- 142.: Komperator
- 143.: Wandler der Phasenverschiebung in eine Steuerspannung
- 144.: Spannungsgesteuerter Generator
- 145.: Stützeingang des Phasendetektors 141
- 146.: Phaseneingang des Detektors 141
- 147.: Ausgang des Phasendetektors 141
- 148.: Trennwiderstände
- 149.: Symmetrischer PWM-Modulator
- 150.: Modulationselement
- 151.: Dreiecksspannungsgenerator
- 152.: Linear-Leistungsverstärker
- 153.: Kompensationsspule
- 154.: Trennkondensator

## Patentansprüche

1. Ultraschallmotor mit einem Multilayeraktor als Multilayerplatte (2) mit einem oder mehreren Friktionselementen (3) oder Friktionsschichten auf seinen Seiten-flächen (4), die angepresst sind oder an die eine oder zwei Friktionsschichten (5) des angetriebenen Elements (7) angepresst werden und eine elektrische Erreger-vorrichtung (114) des Aktors,
**dadurch gekennzeichnet, dass**
die Multilayerplatte (2) zwei sich schneidende, spiegelbildlich abgebildete asym-metrische Generatoren (Gl, Gr) für Ultraschallschwingungen aufweist, ausgeführt in Form von Schichten von Erregerelektroden (51) und allgemeinen Elektroden (52) die abwechselnd mit Schichten piezoelektrischer Keramik (53) angeordnet sind, wobei in dem Multilayeraktor eine zweidimensionale asymmetrische akustische Stehwelle erzeugt wird.

2. Ultraschallmotor mit einem Multilayeraktor nach Anspruch 1,
**dadurch gekennzeichnet, dass**
die Multilayerplatte rechtwinklig oder als Teil eines Rings ausgeführt ist oder jede andere beliebige Form aufweist bei der die mit einem der erwähnten Generatoren erregte asymmetrische Stehwelle, ein Spiegelbild der Welle darstellt, die durch den zweiten Generator erregt wird.

3. Ultraschallmotor mit einem Multilayeraktor nach Anspruch 1,
**dadurch gekennzeichnet, dass**
die Höhe der Multilayerplatte gleich oder etwas kleiner als ein Viertel ihrer Länge ist.

4. Ultraschallmotor mit einem Multilayeraktor nach Anspruch 2,
**dadurch gekennzeichnet, dass**
die abwechselnd angeordneten Schichten von Elektroden und Schichten von polarisierter Piezokeramik des Multilayeraktors in Form einer rechtwinkligen Platte parallel zu ihren Hauptflächen oder parallel zu ihren Seitenflächen oder parallel zu ihren Stirnflächen angeordnet sind.

5. Ultraschallmotor mit einem Multilayeraktor nach Anspruch 2,
**dadurch gekennzeichnet, dass**
die abwechselnd angeordneten Schichten der Elektroden und Schichten von polarisierter Piezokeramik des Multilayeraktors in Form einer eines Teils des Rings parallel zu den Hauptflächen der Multilayerplatte angeordnet sind.

6. Ultraschallmotor mit einem Multilayeraktor nach einem der Ansprüche 1 bis 5,
**dadurch gekennzeichnet,**
**dass** die Schichten der Elektroden und die Schichten der Piezokeramik der Multilayerplatte miteinander bei der Herstellung der Piezokeramik verbunden sind und einen monolithischen Körper bilden.

7. Ultraschallmotor mit einem Multilayeraktor nach einem der Ansprüche 1 bis 6,
**dadurch gekennzeichnet, dass**
die Oberfläche der Multilayerplatte mit einer dünnen Schutzschicht aus Glas bedeckt ist.

8. Ultraschallmotor mit einem Multilayeraktor nach Anspruch 7,
**dadurch gekennzeichnet, dass**
die Multilayerplatte ein oder zwei auf einer oder zwei ihrer Seitenflächen im zentralen Bereich angeordnete Friktionselemente oder zwei oder vier auf einer oder zwei ihrer Seitenflächen in einem Abstand von den Stirnflächen von einem Viertel seiner Länge bezogen auf die Mittellinie angeordnete Friktionselemente aufweist.

9. Ultraschallmotor mit einem Multilayeraktor nach Anspruch 7,
**dadurch gekennzeichnet, dass**
die Friktionselemente als Streifen abriebfesten Glases oder aus mit Teilchen eines abriebfesten Materials angereicherten Glases ausgeführt sind.

10. Ultraschallmotor mit einem Multilayeraktor nach Anspruch 7,
**dadurch gekennzeichnet, dass**
die Friktionselemente oder die Seitenflächen der Multilayerplatte Führungsriefen oder Führungsschienen runder, V-förmiger oder einer anderen Form aufweisen.

11. Ultraschallmotor mit einem Multilayeraktor nach Anspruch 7,
**dadurch gekennzeichnet, dass**
die Friktionselemente aus einem harten abriebfesten Material, aus Oxidkeramik oder einem anderen ähnlichen Material hergestellt und an die Oberfläche der Multilayerplatte mittels eines leichtschmeizenden Glases aufgeschweißt sind.

12. Ultraschallmotor mit einem Multilayeraktor nach Anspruch 10 oder 11,
**dadurch gekennzeichnet, dass**
die Führungsriefen oder Führungsschienen abriebfeste Schichten aufweisen.

13. Ultraschallmotor mit einem Multilayeraktor nach einem der vorangegangenen Ansprüche,
**dadurch gekennzeichnet, dass**
die Multilayerplatte des Oszillators zwei oder vier auf einer seiner Seitenflächen angeordnete Halteelemente aufweist.

14. Ultraschallmotor mit einem Multilayeraktor nach Anspruch 4 oder 5,
**dadurch gekennzeichnet, dass**
der Polarisationsvektor der polarisierten piezoelektrischen Keramik im Wesentlichen senkrecht zur Fläche der Erregerelektroden und der allgemeinen Elektroden verläuft.

15. Ultraschallmotor mit einem Multilayeraktor nach Anspruch 4 oder 5,
**dadurch gekennzeichnet, dass**
der Polarisationsvektor der polarisierten piezoelektrischen Keramik zu den allgemeinen Elektroden hin gerichtet ist oder von den allgemeinen Elektroden weg gerichtet ist.

## Claims

1. Ultrasonic motor comprising a multilayer actuator as multilayer plate (2), having one or more friction elements (3) or friction layers on its lateral faces (4) which are pressed on or against which one or two friction layers (5) of the driven element (7) are pressed, and an electric excitation device (114) of the actuator,
**characterized in that**
the multilayer plate (2) comprises two intersecting mirror-imaged asymmetrical generators (GI, Gr) for ultrasonic oscillations, realized in the form of layers of excitation electrodes (51) and general electrodes (52) which are arranged alternately with layers of piezoelectric ceramics (53), wherein a two-dimensional asymmetrical acoustic standing wave is generated in the multilayer actuator.

2. Ultrasonic motor comprising a multilayer actuator according to claim 1,
**characterized in that**
the multilayer plate is realized as a rectangle or as part of a ring or in any other optional form, wherein the asymmetrical standing wave excited by one of the mentioned generators represents a mirror image of the wave excited by the second generator.

3. Ultrasonic motor comprising a multilayer actuator according to claim 1,
**characterized in that**
the height of the multilayer plate is equal to or slightly smaller than a quarter of its length.

4. Ultrasonic motor comprising a multilayer actuator according to claim 2,
**characterized in that**
the alternately arranged layers of electrodes and layers of polarized piezoelectric ceramics of the multilayer actuator in the form of a rectangular plate are arranged parallel to its principal surfaces or parallel to its lateral faces or parallel to its end faces.

5. Ultrasonic motor comprising a multilayer actuator according to claim 2,
**characterized in that**
the alternately arranged layers of the electrodes and layers of polarized piezoelectric ceramics of the multilayer actuator in the form of a part of the ring are arranged parallel to the principal surfaces of the multilayer plate.

6. Ultrasonic motor comprising a multilayer actuator according to one of claims 1 to 5,
**characterized in that**
the layers of the electrodes and the layers of the piezoelectric ceramics of the multilayer plate are connected to each other during the production of the piezoelectric ceramics and form a monolithic body.

7. Ultrasonic motor comprising a multilayer actuator according to one of claims 1 to 6,
**characterized in that**
the surface of the multilayer plate is covered with a thin protective layer of glass.

8. Ultrasonic motor comprising a multilayer actuator according to claim 7,
**characterized in that**
the multilayer plate comprises one or two friction elements which are arranged on one or two of its lateral faces in the central part, or two or four friction elements which are arranged on one or two of its lateral faces at a distance from the end faces of a quarter of its length relative to the center line.

9. Ultrasonic motor comprising a multilayer actuator according to claim 7,
**characterized in that**
the friction elements are realized as stripes of abrasion-proof glass or glass enriched with particles of an abrasion-proof material.

10. Ultrasonic motor comprising a multilayer actuator according to claim 7,
**characterized in that**
the friction elements or the lateral faces of the multilayer plate comprise guide grooves or guide rails having a round, V-shaped or any other form.

11. Ultrasonic motor comprising a multilayer actuator according to claim 7,
**characterized in that**
the friction elements are made of a hard, abrasion-proof material, of oxide ceramics or of another similar material and are welded onto the surface of the multilayer plate by means of a low-melting glass.

12. Ultrasonic motor comprising a multilayer actuator according to claim 10 or 11,
**characterized in that**
the guide grooves or guide rails comprise abrasion-proof layers.

13. Ultrasonic motor comprising a multilayer actuator according to one of the preceding claims,
**characterized in that**
the multilayer plate of the oscillator comprises two or four holding members which are arranged on one of its lateral faces.

14. Ultrasonic motor comprising a multilayer actuator according to claim 4 or 5,
**characterized in that**
the polarization vector of the polarized piezoelectric ceramics extends substantially perpendicular to the surface of the excitation electrodes and the general electrodes.

15. Ultrasonic motor comprising a multilayer actuator according to claim 4 or 5,
**characterized in that**
the polarization vector of the polarized piezoelectric ceramics is directed towards the general electrodes or directed away from the general electrodes.

## Revendications

1. Moteur à ultrasons comprenant un acteur multicouches sous forme de plaque multicouches (2) dotée d'un ou plusieurs éléments de friction (8) ou d'une ou plusieurs couches de friction sur ses surfaces latérales (4) qui sont pressées contre une ou deux couches de friction (5) de l'élément entraîné (7), ou contre lesquelles sont pressées une ou deux couches de friction (5) de l'élément entraîné (7), et comprenant un dispositif d'excitation électrique (114) pour l'acteur,
**caractérisé en ce que**
la plaque multicouches (2) comprend deux générateurs asymétriques (GI, Gr), qui se recoupent et sont formés comme des images symétriques, pour des oscillations ultrasonores, réalisés sous la forme de couches d'électrodes d'excitation (51) et d'électrodes générales (52), agencées en alternance avec des couches de céramique piézoélectrique (53), de sorte qu'une onde stationnaire acoustique asymétrique bidimensionnelle est engendrée dans l'acteur multicouches.

2. Moteur à ultrasons comprenant un acteur multicouches selon la revendication 1,
**caractérisé en ce que** la plaque multicouches est réalisée sous forme rectangulaire ou sous forme d'une partie d'anneau, ou présente toute autre forme quelconque dans laquelle l'onde stationnaire asymétrique excitée par les générateurs précités représente une image symétrique de l'onde qui est excitée par le second générateur.

3. Moteur à ultrasons comprenant un acteur multicouches selon la revendication 1,
**caractérisé en ce que** la hauteur de la plaque multicouches est égale à un quart de sa longueur, ou légèrement plus faible.

4. Moteur à ultrasons comprenant un acteur multicouches selon la revendication 2,
**caractérisé en ce que** les couches agencées en alternance d'électrodes et de couches de piézocéramique polarisée de l'acteur multicouches sous la forme d'une plaque rectangulaire sont agencées parallèlement à ses surfaces principales ou parallèlement à ses surfaces latérales, ou encore parallèlement à ses surfaces frontales.

5. Moteur à ultrasons comprenant un acteur multicouches selon la revendication 2,
**caractérisé en ce que** les couches agencées en alternance d'électrodes et de couches de piézocéramique polarisée de l'acteur multicouches sous la forme d'une partie d'un anneau sont agencées parallèlement aux surfaces principales de la plaque multicouches.

6. Moteur à ultrasons comprenant un acteur multicouches selon l'une des revendications 1 à 5,
**caractérisé en ce que** les couches des électrodes et les couches de piézocéramique de la plaque multicouches sont reliées ensemble lors de la fabrication de la piézocéramique et forment un corps monolithique.

7. Moteur à ultrasons comprenant un acteur multicouches selon l'une des revendications 1 à 6,
**caractérisé en ce que** la surface de la plaque multicouches est revêtue d'une mince couche de protection en verre.

8. Moteur à ultrasons comprenant un acteur multicouches selon la revendication 7,
**caractérisé en ce que** la plaque multicouches comprend un ou deux éléments de friction, agencés dans la zone centrale sur une ou deux de ses surfaces latérales, ou bien deux ou quatre éléments de friction, agencés sur une ou deux de ses surfaces latérales, à une distance depuis les surfaces frontales égale à un quart de sa longueur par référence à la ligne médiane.

9. Moteur à ultrasons comprenant un acteur multicouches selon la revendication 7,
**caractérisé en ce que** les éléments de friction sont réalisés sous la forme de rubans de verre résistant à l'abrasion ou de verre enrichi avec des particules d'un matériau résistant à l'abrasion.

10. Moteur à ultrasons comprenant un acteur multicouches selon la revendication 7,
**caractérisé en ce que** les éléments de friction ou les surfaces latérales de la plaque multicouches comportent des stries de guidage ou des rails de guidage de forme arrondie, en forme de V, ou présentant une autre forme.

11. Moteur à ultrasons comprenant un acteur multicouches selon la revendication 7,
**caractérisé en ce que** les éléments de friction sont réalisés en un matériau dur résistant à l'abrasion, en céramique à base d'oxyde ou en un autre matériau analogue, et sont soudés sur la surface de la plaque multicouches au moyen d'un verre à bas point de fusion.

12. Moteur à ultrasons comprenant un acteur multicouches selon la revendication 10 ou 11,
**caractérisé en ce que** les stries de guidage ou les rails de guidage comprennent des couches résistant à l'abrasion.

13. Moteur à ultrasons comprenant un acteur multicouches selon l'une des revendications précédentes,
**caractérisé en ce que** la plaque multicouches de l'oscillateur comprend deux ou quatre éléments de retenue agencés sur l'une de ses surfaces latérales.

14. Moteur à ultrasons comprenant un acteur multicouches selon la revendication 4 ou 5,
**caractérisé en ce que** le vecteur de polarisation de la céramique piézoélectrique polarisée s'étend sensiblement perpendiculairement à la surface des électrodes d'excitation et des électrodes générales.

15. Moteur à ultrasons comprenant un acteur multicouches selon la revendication 4 ou 5,
**caractérisé en ce que** le vecteur de polarisation de la céramique piézoélectrique polarisée est dirigé vers les électrodes générales ou est dirigé en éloignement des électrodes générales.
